(19) **Europäisches Patentamt**
**European Patent Office**
**Office européen des brevets**

(11) **EP 3 720 023 B1**

(12) **EUROPEAN PATENT SPECIFICATION**

(45) Date of publication and mention
of the grant of the patent:
**07.02.2024 Bulletin 2024/06**

(51) International Patent Classification (IPC):
**H03M 13/13** (2006.01)    **H03M 13/29** (2006.01)
**H03M 13/37** (2006.01)    **H03M 13/45** (2006.01)
**H04L 1/00** (2006.01)

(21) Application number: **18915137.6**

(22) Date of filing: **29.12.2018**

(52) Cooperative Patent Classification (CPC):
**H03M 13/3746; H03M 13/13; H03M 13/29;**
**H03M 13/3776; H03M 13/45; H04L 1/005;**
**H04L 1/0057; H04L 1/0065**

(86) International application number:
**PCT/CN2018/125870**

(87) International publication number:
**WO 2019/200971 (24.10.2019 Gazette 2019/43)**

(54) **POLAR CODE DECODING METHOD AND COMMUNICATION DEVICE**

DECODIERUNGSVERFAHREN UND DECODIERUNGSVORRICHTUNG FÜR POLARCODES

PROCÉDÉ DE DÉCODAGE DE CODE POLAIRE ET DISPOSITIF DE COMMUNICATION

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **18.04.2018 CN 201810348125**

(43) Date of publication of application:
**07.10.2020 Bulletin 2020/41**

(73) Proprietor: **HUAWEI TECHNOLOGIES CO., LTD.**
**Shenzhen, Guangdong 518129 (CN)**

(72) Inventors:
- **LI, Bin**
**Shenzhen, Guangdong 518129 (CN)**
- **LIU, Ling**
**Shenzhen, Guangdong 518129 (CN)**
- **SHEN, Hui**
**Shenzhen, Guangdong 518129 (CN)**
- **GU, Jiaqi**
**Shenzhen, Guangdong 518129 (CN)**

(74) Representative: **Pfenning, Meinig & Partner mbB**
**Patent- und Rechtsanwälte**
**Theresienhöhe 11a**
**80339 München (DE)**

(56) References cited:
**WO-A1-2018/060976**    **CN-A- 106 130 690**
**US-A1- 2014 019 820**

- **LIU ZHENZHEN ET AL: "Parallel concatenated systematic polar code based on soft successive cancellation list decoding", 2017 20TH INTERNATIONAL SYMPOSIUM ON WIRELESS PERSONAL MULTIMEDIA COMMUNICATIONS (WPMC), IEEE, 17 December 2017 (2017-12-17), pages 181-184, XP033326136, DOI: 10.1109/WPMC.2017.8301804 [retrieved on 2018-02-22]**
- **KOIKE-AKINO TOSHIAKI ET AL: "Irregular Polar Turbo Product Coding for High-Throughput Optical Interface", 2018 OPTICAL FIBER COMMUNICATIONS CONFERENCE AND EXPOSITION (OFC), OSA, 11 March 2018 (2018-03-11), pages 1-3, XP033357478, [retrieved on 2018-06-13]**
- **IDO: "List Decoding of Polar Codes", IEEE TRANSACTIONS ON INFORMATION THEORY, 31 May 2015 (2015-05-31), pages 2213-2226, XP011578805, DOI: 10.1109/TIT.2015.2410251**

**(Cont. next page)**

• **FAYYAZ UBAID U ET AL: "Low-Complexity Soft-Output Decoding of Polar Codes", IEEE JOURNAL ON SELECTED AREAS IN COMMUNICATIONS, IEEE SERVICE CENTER, PISCATAWAY, US, vol. 32, no. 5, 1 May 2014 (2014-05-01), pages 958-966, XP011546180, ISSN: 0733-8716, DOI: 10.1109/JSAC.2014.140515 [retrieved on 2014-04-23]**

## Description

## TECHNICAL FIELD

This application relates to the field of communications technologies, and in particular, to a polar code decoding method and a communications device.

## BACKGROUND

In recent years, as a polar code (Polar Code) is included in a wireless communications 5G standard, research on decoding of the polar code becomes a hot issue in the field of communications. Currently, based on decoding outputs of the polar code, mainstream polar code decoding methods may be classified into two types: polar code hard bit decoding and polar code soft bit decoding. Polar code hard bit decoding means that a decoder directly determines, based on a received signal, to send an information bit. Polar code soft bit decoding means that a decoder calculates, based on a received signal, a soft bit value (for example, a log-likelihood ratio Log-Likelihood-Ratio) of sending information. Then, a final hard decision may be made on the obtained soft bit value to implement a hard bit output. Therefore, soft bit decoding is more flexible and has stronger adaptability than hard bit decoding. Currently, main polar code hard bit decoding methods include successive cancellation (Successive Cancellation, SC) decoding, successive cancellation list (Successive Cancellation List, SCL) decoding, cyclic redundancy check-aided successive cancellation list (CRC-Aided Successive Cancellation List, CA-SCL) decoding, and the like. Soft bit decoding methods mainly include belief propagation (Belief Propagation) decoding and soft bit cancellation (Soft Cancellation, SCAN) decoding. In terms of decoding performance, SC decoding is the worst, and performance of BP decoding and that of SCAN decoding are close to each other, and both are slightly better than that of SC decoding. The SCL decoding is greatly improved compared with the SC decoding, and the CA-SCL obtained by combining the CRC check and the SCL decoding can make performance of the polar code better than that of an LDPC code and that of a turbo code. Therefore, currently, the SCL decoding and the CA-SCL decoding are mainly used in an actual system. However, both the SCL decoding and the CA-SCL decoding are polar hard bit decoding, and a soft bit value cannot be directly output. Consequently, the two schemes have some limitations in application scenarios. In some specific scenarios, polar soft bit decoding needs to be used for matching. In this case, currently, only BP decoding or SCAN decoding with average performance can be used to achieve an objective of a soft bit output. Therefore, how to design a decoding manner that can both satisfy a soft bit output and ensure high decoding performance is a technical problem that needs to be resolved currently.

Z. Liu, K. Niu and J. Lin, "Parallel concatenated systematic polar code based on soft successive cancellation list decoding," 2017 20th International Symposium on Wireless Personal Multimedia Communications (WPMC), 2017, pp. 181-184, investigates parallel concatenated systematic polar code (PCSPC) with soft successive cancellation list (SSCL) decoding algorithm. In this document, polar decoders are implemented as SISO modules, each of which performing the steps of SCL decoding for generating L paths and associated path metrics, encoding of the L paths through the graph, and generating bit LLRs for each bit based on the value of this bit in the L encoded paths and on the path metrics. The publication by Fayyaz Ubaid et al: "Low-Complexity Soft-Output Decoding of Polar Codes", IEEE Journal on Selected Areas in Communications, vol. 32, no. 5, May 2014, pages 958-966, XP011546180, ISSN: 0733-8716, DOI: 10.1109/JSAC.2014.140515, discloses the SCAN decoder, which generates soft information for information and for coded bits by following the scheduling of a SC decoder with LLRs being propagated through the polar graph in the information-to-code direction instead of propagating hard decision values as in the SC decoder.

## SUMMARY

This application provides a claimed invention embodied in a polar polar code decoding method and a communications device according to the independent claims, to both satisfy a soft bit output and ensure high decoding performance.

According to a first aspect, an embodiment of the present invention provides a polar polar code decoding method, including: obtaining a to-be-decoded sequence, where a length of the to-be-decoded sequence is N, and N is a positive integer; performing successive cancellation-list SC-list decoding on the to-be-decoded sequence, to obtain L first paths and a weight value of each of the L first paths, where L is a positive integer, each of the L first paths includes M bits, and M is a positive integer less than or equal to N; calculating soft bit values of a first-phase decoding sequence based on the L first paths and the weight value of each of the L first paths, where a length of the first-phase decoding sequence is P. The to-be-decoded sequence is obtained by receiving by a receiving device a channel output signal from a channel, wherein a coded signal is sent through the channel, wherein the coded signal is obtained, by a sending apparatus, by source coding and channel coding on a to-be-sent signal and rate matching and digital modulation on the coded signal, wherein the to-be-sent signal is a signal before coding and includes a fixed bit and an information bit, and P is a positive integer less than or equal to M; and decoding the soft bit values of the first-phase decoding sequence to obtain a decoding result. Through implementation of this embodiment of the present invention, a soft bit value may be further extracted from a hard bit output of an SCL with better decoding performance, to achieve an effect of a soft bit output, so that a hard bit decoding manner is applicable to more application scenarios, thereby both satisfying a soft bit output and ensuring high decoding performance.

N=M=P. Either, the soft bit values of the signal before coding are directly calculated, and, after the soft bit values of the first-phase decoding sequence are calculated, soft bit values of the second-stage decoding sequence may be further calculated based on the soft bit values of the first-phase decoding sequence. That is, after the calculating soft bit values of a first-phase decoding sequence based on the L first paths and the weight value of each of the L first paths, the method further includes: performing soft bit iterative decoding on the soft bit values of the first-phase decoding sequence to obtain the soft bit values of the second-stage decoding sequence, where a length of the second-stage decoding sequence is N. Or, the soft bit values of the signal before coding are first calculated, and then the soft bit values of the signal after coding are calculated based on the factor graph of the polar code and the performing SC-list decoding on the to-be-decoded sequence, to obtain L first paths, and a weight value of each of the L first paths is specifically: performing SC-list decoding on the to-be-decoded sequence, to obtain L second paths, where each of the second paths includes N bits; performing polar encoding on each of the L second paths to obtain the L first paths; and calculating a weight value of each of the L first paths based on a Euclidean distance between each of the L first paths and the to-be-decoded sequence.

In a possible design, an implementation of the performing soft bit iterative decoding on the soft bit values of the first-phase decoding sequence to obtain soft bit values of a second-phase decoding sequence may be: performing a 2x2 factor graph (factor graph) soft bit iterative decoding layer by layer on the soft bit values of the first-phase decoding sequence to obtain the soft bit values of the second-phase decoding sequence; or performing NxN factor graph soft bit iterative decoding on the soft bit values of the first-phase decoding sequence to obtain the soft bit values of the second-stage decoding sequence.

In a possible design, the calculating a weight value of each of the L first paths based on a Euclidean distance between each of the L first paths and the to-be-decoded sequence is specifically: calculating the weight value of each of the L first paths based on the following formula, where the formula is $P_m = \ln(|W^m - Y_1^N|^2)$, $P_m$ is a weight value of an $m^{th}$ path in the L first paths, $Y_l^N$ is the to-be-decoded sequence, $W^m$ is the $m^{th}$ path in the L first paths, $|W^m - Y_l^N|^2$ is a Euclidean distance between the $m^{th}$ path and the to-be-decoded sequence, and $1 \leq m \leq L$.

In a possible design, the $i^{th}$ bit in the first-phase decoding sequence is $X_i$, and $1 \leq i \leq N$. If the $i^{th}$ bits of the L first paths are all 0, a soft bit value of the $i^{th}$ bit $X_i$ in the first-phase decoding sequence is determined by using a minimum weight value of a path whose $i^{th}$ bit is 0 in the L first paths, where $1 \leq i \leq N$. If the $i^{th}$ bits of the L first paths are all 1, a soft bit value of the $i^{th}$ bit $X_i$ in the first-phase decoding sequence is determined by using a minimum weight value of a path whose $i^{th}$ bit is 1 in the L first paths. Otherwise, a soft bit value of the $i^{th}$ bit $X_i$ in the first-phase decoding sequence is determined by using a minimum weight value of a path whose $i^{th}$ bit is 0 in the L first paths and a minimum weight value of a path whose $i^{th}$ bit is 1 in the L first paths.

In a possible design, if the $i^{th}$ bits of the L first paths are all 0, the soft bit value of the $i^{th}$ bit $X_i$ in the first-phase decoding sequence is equal to a product of a fourth preset value and a minimum weight value of a path whose $i^{th}$ bit is 0 in the L first paths. If the $i^{th}$ bits of the L first paths are all 1, the soft bit value of the $i^{th}$ bit $U_i$ in the first-phase decoding sequence is equal to a product of a fifth preset value and a minimum weight value of a path whose $i^{th}$ bit is 1 in the L first paths. Otherwise, the soft bit value of the $i^{th}$ bit $U_i$ in the first-phase decoding sequence is equal to a difference between a minimum weight value among weight values of paths whose $i^{th}$ bits are 0 in the L first paths and a minimum weight value of paths whose $i^{th}$ bits are 1 in the L first paths.

In a possible design, N=M=P, that is, code lengths of the to-be-decoded sequence, the first path, and the first-phase decoding sequence are all equal. That is, the soft bit values of the first-phase decoding sequence are calculated after SCL decoding is completed.

According to a second aspect, this application provides a communications device, and the communications device may include a plurality of function modules or units, configured to correspondingly perform the polar polar code decoding method according to the first aspect, or the polar polar code decoding method according to any one of the possible implementations of the first aspect.

According to a third aspect, this application provides a communications device, and the communications device is configured to perform the polar polar code decoding method according to the first aspect. The terminal may include: a memory, a processor coupled to the memory, and a transceiver. The transceiver is configured to communicate with another communications device (such as a terminal or a network device). The memory is configured to store implementation code of the polar polar code decoding method according to the first aspect. The processor is configured to execute program code stored in the memory, that is, perform the polar polar code decoding method according to the first aspect, or the polar polar code decoding method according to any one of the possible implementations of the first aspect.

According to a fourth aspect, a computer-readable storage medium is provided. The readable storage medium stores an instruction, and when the instruction is run on a computer, the computer is enabled to perform the polar polar code decoding method according to the first aspect.

According to a fifth aspect, a computer program product including an instruction is further provided. When the computer program product is run on a computer, the computer is enabled to perform the polar polar code decoding method according to the first aspect.

According to a sixth aspect, this application provides a communications chip. The communications chip may include a processor and one or more interfaces coupled to the processor. The processor may be configured to invoke, from a memory, an implementation program of the polar polar code decoding method according to the first aspect, or the polar polar code decoding method according to any one of the possible implementations of the first aspect, and execute an instruction included in the program. The interface may be configured to output a processing result of the processor.

**BRIEF DESCRIPTION OF DRAWINGS**

To describe the technical solutions in the embodiments of this application or in the background more clearly, the following describes the accompanying drawings required in the embodiments of this application or the background.

FIG. 1 is a schematic diagram of an architecture of a communications system according to an embodiment of this application;

FIG. 2 is a schematic diagram of a hardware structure of a terminal device according to an embodiment of this application.

FIG. 3 is a schematic diagram of a hardware structure of a network device according to an embodiment of this application;

FIG. 4 is a schematic diagram of channel coding in a communication link according to an embodiment of this application;

FIG. 5 is a factor graph corresponding to a polar code with a code length N = 8 according to an embodiment of this application;

FIG. 6 is a schematic diagram of a calculation process of a 2x2 factor graph of a polar code according to an embodiment of this application;

FIG. 7 is a schematic diagram of a tree structure of SCL decoding according to an embodiment of this application;

FIG. 8 is a schematic diagram of a receive-end interference cancellation decoding scheme in a two-user MAC communications system according to an embodiment of this application;

FIG. 9 is a schematic flowchart of a polar code decoding method according to an embodiment of this application;

FIG. 10 is a schematic principle diagram of obtaining a candidate path and a weight value based on an SCL decoding algorithm according to an embodiment of this application;

FIG. 11 is a schematic diagram of an 8x8 factor graph of a polar code according to an embodiment of this application;

FIG. 12 is a schematic principle diagram of coding a candidate path obtained through SCL decoding to obtain a coded candidate path according to an embodiment of this application;

FIG. 13 is a schematic principle diagram of calculating a soft bit value in an SCL decoding process according to an embodiment of this application;

FIG. 14 is a schematic diagram of decoding corresponding to a concatenated coding scheme according to an embodiment of this application;

FIG. 15 is a flowchart of an extended decoding algorithm according to an embodiment of this application;

FIG. 16 is a flowchart of an interference cancellation algorithm according to an embodiment of this application;

FIG. 17 is a flowchart of another interference cancellation algorithm according to an embodiment of this application;

FIG. 18 is a functional block diagram of a communications device according to an embodiment of this application; and

FIG. 19 is a schematic structural diagram of a communications chip according to an embodiment of this application.

**DESCRIPTION OF EMBODIMENTS**

The following describes the embodiments of this application with reference to the accompanying drawings in the embodiments of this application.

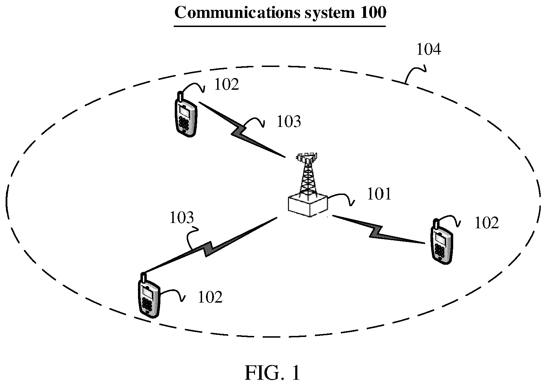

FIG. 1 is a schematic diagram of a communications system according to an embodiment of this application. The communications system 100 may include at least one network device 101 (only one is shown) and one or more terminal devices 102 connected to the network device 101.

The network device 101 may perform wireless communication with the terminal device 102 by using one or more antennas. Each network device 101 may provide communication coverage for a coverage area 104 corresponding to the network device 101. The coverage area 104 corresponding to the network device 101 may be divided into a plurality of sectors (sector), and one sector corresponds to a part of the coverage area (not shown).

In this embodiment of this application, the network device 101 may include a base transceiver station (Base Transceiver Station), a wireless transceiver, a basic service set (Basic Service Set, BSS), an extended service set (Extended Service Set, ESS), and a NodeB (NodeB), an evolved NodeB (evolved NodeB, eNB or eNodeB), a next-generation NodeB (next-generation NodeB, gNB), or the like. The communications system 100 may include several different types of network devices 101, for example, a macro base station (macro base station), a micro base station (micro base station), and the like. The network device 101 may be alternatively a small cell, a transmission reference point (Transmission Reference Point, TRP), or the like. The network device 101 may apply different wireless technologies, for example, a cell radio access technology or a WLAN radio access technology.

In this embodiment of this application, the terminal device 102 is a device that has a wireless transceiver function and may be deployed on land, including an indoor or outdoor device, a handheld device, a wearable device, or an in-vehicle device; or may be deployed on the water surface (such as a ship); or may be deployed in the air (for example, on an airplane, a balloon, and a satellite). The terminal device may be a mobile phone (mobile phone), a tablet computer (Pad), a computer having a wireless transceiver function, a virtual reality (Virtual Reality, VR) terminal device, an augmented reality (Augmented Reality, AR) terminal device, a wireless terminal in industrial control (industrial control), a wireless terminal in self driving (self driving), a wireless terminal in remote medical (remote medical), a wireless terminal in a smart grid (smart grid), a wireless terminal in transportation safety (transportation safety), a wireless terminal in a smart city (smart city), a wireless terminal in a smart home (smart home), or the like. An application scenario is not limited in this embodiment of this application. Sometimes, the terminal device may also be referred to as user equipment (User Equipment, UE), a terminal (terminal), an access terminal, a UE unit, a UE station, a mobile device, a mobile station, a mobile console (mobile station), a mobile terminal, a mobile client, a mobile unit (mobile unit), a remote station, a remote terminal device, a remote unit, a radio unit, a wireless communications device, a user agent, a user apparatus, or the like.

The terms "system" and "network" may be used interchangeably in the embodiments of this application. "A plurality of" means two or more. In view of this, "a plurality of" in this embodiment of this application may also be understood as "at least two". "And/or" describes an association relationship for describing associated objects and represents that three relationships may exist. For example, A and/or B may represent the following three cases: Only A exists, both A and B exist, and only B exists. In addition, the character "/" generally indicates an "or" relationship between the associated objects.

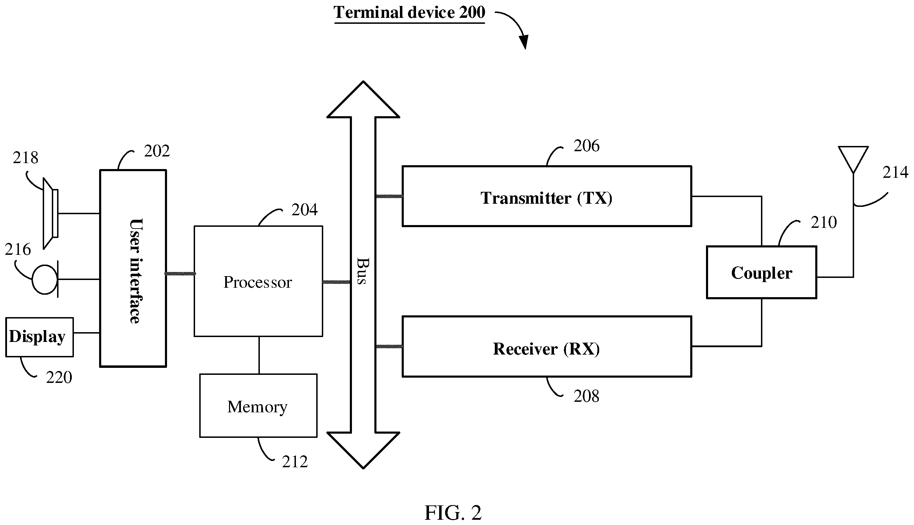

FIG. 2 shows a terminal device according to an embodiment of this application. As shown in FIG. 2, the terminal device 200 may include an input/output module (including an audio input/output module 218, a key input module 216, a display 220, and the like), a user interface 202, one or more processors 204, a transmitter 206, a receiver 208, a coupler 210, an antenna 214, and a memory 212. These components may be connected by using a bus or in another manner. In FIG. 2, an example in which the components are connected by using a bus is used.

The antenna 214 may be configured to convert electromagnetic energy into an electromagnetic wave in free space, or convert an electromagnetic wave in free space into electromagnetic energy in a transmission line. The coupler 210 is configured to divide a mobile communication signal received by the antenna 214 into a plurality of signals, and allocate the plurality of signals to a plurality of receivers 208.

The transmitter 206 may be configured to transmit a signal output by the processor 204.

The receiver 208 may be configured to receive a mobile communication signal received by the antenna 214.

In this embodiment of this application, the transmitter 206 and the receiver 208 may be considered as a wireless modem. In the terminal device 200, there may be one or more transmitters 206 and one or more receivers 208.

In addition to the transmitter 206 and the receiver 208 shown in FIG. 2, the terminal device 200 may further include another communications component, for example, a GPS module, a Bluetooth (Bluetooth) module, or a wireless fidelity (Wireless Fidelity, Wi-Fi) module. Not limited to the foregoing described wireless communication signal, the terminal device may further support another wireless communication signal, for example, a satellite signal, or a short-wave signal. Not limited to wireless communication, the terminal device 200 may be further configured with a wired network interface (for example, a LAN interface) 201 to support wired communication.

The input/output module may be configured to implement interaction between the terminal device 200 and a user/an external environment, and may mainly include the audio input/output module 218, the key input module 216, the display 220, and the like. Specifically, the input/output module may further include: a camera, a touchscreen, a sensor, and the like. All the input/output modules communicate with the processor 204 by using the user interface 202.

The memory 212 may be coupled to the processor 204 through the bus or an input/output port, and the memory 212 may be alternatively integrated with the processor 204. The memory 212 is configured to store various software programs and/or a plurality of groups of instructions. Specifically, the memory 212 may include a high-speed random access memory, and may also include a nonvolatile memory, for example, one or more magnetic disk storage devices, a flash storage device, or another nonvolatile solid-state storage device. The memory 212 may store an operating system (briefly referred to as a system below), for example, an embedded operating system such as ANDROID, IOS, WINDOWS, or LINUX. The memory 212 may further store a network communications program. The network communications program may be used to communicate with one or more additional devices, terminal devices, and network devices. The memory 212 may further store a user interface program. The user interface program may vividly display content of an application program by using a graphical operating window, and receive, by using an input control such as a menu, a dialog box, and a key, a control operation performed by a user on the application program.

In this embodiment of this application, the memory 212 may be configured to store an implementation program that is on a side of the terminal device 200 and that is of the polar polar code decoding method provided in one or more embodiments of this application. For implementation of the polar polar code decoding method provided in one or more embodiments of this application, refer to a subsequent embodiment.

The processor 204 may be configured to read and execute a computer-readable instruction. Specifically, the processor 204 may be configured to invoke a program stored in the memory 212, for example, a program for implementing, on the terminal device 200 side, the polar polar code decoding method provided in one or more embodiments of this application, and execute an instruction included in the program to implement the method in a subsequent embodiment. The processor 204 may support one or more of global system for mobile communications (Global System for Mobile Communication, GSM) (2G) communication, wideband code division multiple access (Wideband Code Division Multiple Access, WCDMA) (3G) communication, long term evolution (Long Term Evolution, LTE) (4G) communication, 5G communication, and the like. Optionally, when the processor 204 specifically sends any message or data by driving or controlling the transmitter 206. Optionally, when the processor 204 receives any message or data, the processor 204 performs the reception specifically by driving or controlling the receiver 208. Therefore, the processor 204 may be considered as a control center for performing sending or reception, and the transmitter 206 and the receiver 208 are specific executors of sending and reception operations.

It may be understood that the terminal device 200 may be the terminal device 102 in the communications system 100 shown in FIG. 1, and may be implemented as user equipment (User Equipment, UE), a terminal (terminal), an access terminal, a UE unit, a UE station, a mobile device, a mobile station, a mobile console (mobile station), a mobile terminal, or the like.

It should be noted that the terminal device 200 shown in FIG. 2 is merely an implementation of the embodiments of this application, and in actual application, the terminal device 200 may further include more or fewer components. This is not limited herein.

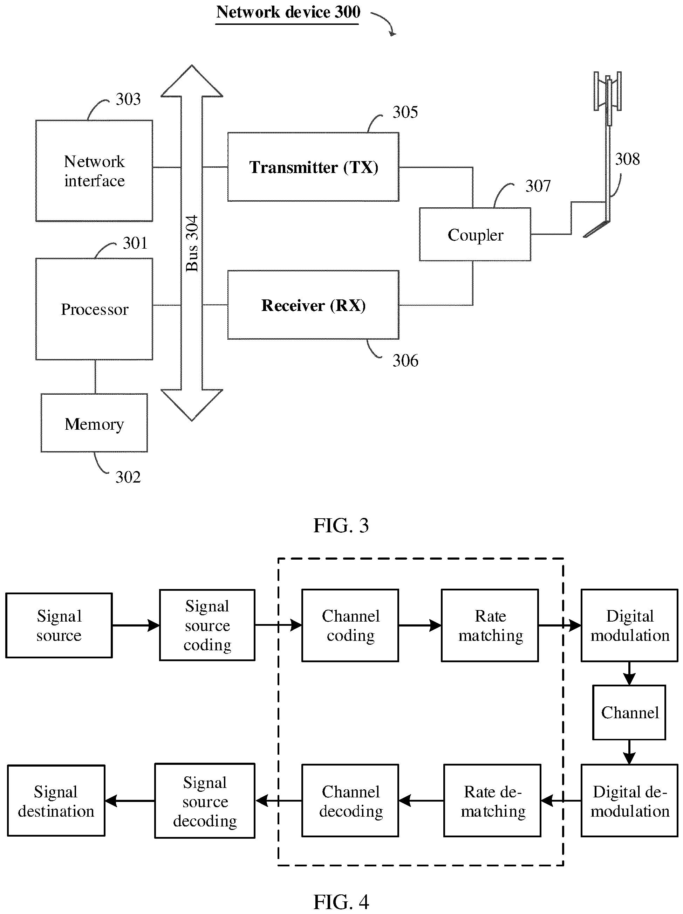

FIG. 3 shows a network device according to an embodiment of this application. As shown in FIG. 3, the network device 300 may include one or more processors 301, a memory 302, a network interface 303, a transmitter 305, a receiver 306, a coupler 307, and an antenna 308. These components may be connected by using a bus 304 or in another manner. In FIG. 3, an example in which the components are connected by using a bus is used.

The network interface 303 may be used by the network device 300 for communicating with another communications device, for example, another network device. Specifically, the network interface 303 may be a wired interface.

The transmitter 305 may be configured to perform transmission processing, for example, perform signal modulation on, a signal that is output by the processor 301. The receiver 306 may be configured to perform reception processing, for example, signal demodulation, on a mobile communication signal received by the antenna 308. In some embodiments of this application, the transmitter 305 and the receiver 306 may be considered as a wireless modem. In the network device 300, there may be one or more transmitters 305 and one or more receivers 306. The antenna 308 may be configured to convert electromagnetic energy in a transmission line into an electromagnetic wave in free space, or convert an electromagnetic wave in free space into electromagnetic energy in a transmission line. The coupler 307 may be configured to divide a mobile communication signal into a plurality of signals, and allocate the plurality of signals to a plurality of receivers 306.

The memory 302 may be coupled to the processor 301 through the bus 304 or an input/output port, and the memory 302 may be alternatively integrated with the processor 301. The memory 302 is configured to store various software programs and/or a plurality of groups of instructions. Specifically, the memory 302 may include a high-speed random access memory, and may further include a non-volatile memory, for example, one or more disk storage devices, a flash device, or another non-volatile solid-state storage device. The memory 302 may store an operating system (referred to as a system below), for example, an embedded operating system such as uCOS, VxWorks, or RTLinux. The memory 302 may further store a network communications program. The network communications program may be used for communicating with one or more additional devices, one or more terminal devices, or one or more network devices.

The processor 301 may be configured to perform radio channel management, calling implementation, and communications link establishment and disconnecting, and provide cell handover control and the like for a user in a local control area. Specifically, the network device processor 301 may include: an administration module/communication module (Administration Module/Communication Module, AM/CM) (a center for speech channel switching and information exchange), a basic module (Basic Module, BM) (configured to implement call processing, signaling processing, radio resource management, radio link management, and circuit maintenance functions), a transcoder and sub-multiplexer (Transcoder and SubMultiplexer, TCSM) (configured to implement multiplexing/demultiplexing and transcoding functions), and the like.

In this embodiment of this application, the processor 301 may be configured to read and execute a computer-readable instruction. Specifically, the processor 301 may be configured to invoke a program stored in the memory 302, for example, an implementation program that is on a side of the network device 300 and that is of the polar polar code decoding method provided in one or more embodiments of this application, and execute an instruction included in the program.

It may be understood that the network device 300 may be the network device 101 in the communications system 100 shown in FIG. 1, and may be implemented as a base station, a wireless transceiver, a basic service set (BSS), an extended service set (ESS), and a NodeB (NodeB), an eNodeB, a gNB, or the like.

It should be noted that the network device 300 shown in FIG. 3 is merely an implementation of the embodiments of this application, and in actual application, the network device 300 may further include more or fewer components. This is not limited herein.

It should be noted that in descriptions in the following embodiments, a receiving apparatus may be the foregoing terminal device, and a sending apparatus may be the foregoing network device. Alternatively, in descriptions in the following embodiments, a receiving apparatus may be the foregoing network device, and a sending apparatus may be the foregoing terminal device.

FIG. 4 is a schematic diagram of channel coding in a communication link. A sending apparatus performs source coding and channel coding on a to-be-sent signal $U_1^N$ (that is, a source) to obtain a coded signal $X_1^N$, then performs rate matching and digital modulation on the coded signal $X_1^N$, and sends the coded signal $X_1^N$ through a channel. A receiving apparatus receives a channel output signal $Y_1^N$ from the channel, performs digital demodulation, de-rate matching, channel decoding, and source decoding, and finally restores the signal $U_1^N$ (that is, a sink). The to-be-sent signal $U_1^N$ includes N bits in total: $U_1$, $U_2$, ..., and $U_N$, where N is a length of the to-be-sent signal, or referred to as a code length. Correspondingly, the coded signal $X_1^N$ includes N bits in total: $X_1$, $X_2$, ..., and Xrr. The channel output signal $Y_1^N$ includes N bits in total: $Y_1$, $Y_2$, ..., and $Y_N$. In this application, the to-be-sent signal $U_1^N$ may also be referred to as a signal before coding, and the coded signal $X_1^N$ is a signal after coding. The to-be-sent signal $U_1^N$ may also be referred to as a to-be-sent sequence or a to-be-restored sequence, the channel output signal $Y_1^N$ may also be referred to as a received sequence or a to-be-decoded sequence, and the coded signal $X_1^N$ may also be referred to as a coded sequence. The signal $U_1^N$ before coding includes a fixed bit (Frozen bits) and an information bit (Information bits). In a polar code coding process, some bits in $U_1^N$ are used to carry information and are referred to as information bits, and a set of indexes of these bits is denoted by $\mathscr{F}$; and other bits are set to fixed values that are agreed on by a transmit end and a receive end in advance and are referred to as fixed bits, and a set of indexes of these bits is denoted by a complementary set $\mathscr{I}$ of $\mathscr{F}$. A manner of selecting the information bit index set $\mathscr{F}$ is not limited in this application. The information bits may further include various types of check bits.

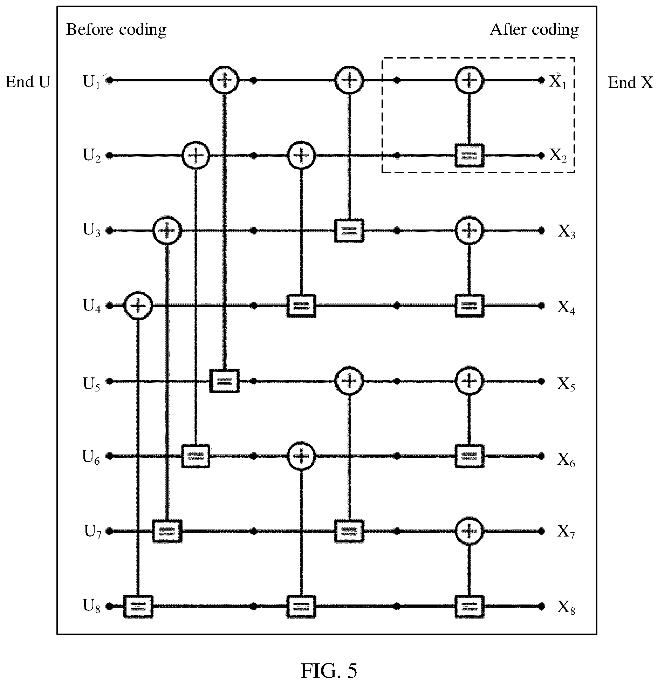

In some specific scenarios, for example, soft decoding iteration of concatenating a polar code and iterative decoding interference cancellation in a multi-user scenario, polar soft bit decoding needs to be used for matching. In this case, BP decoding or SCAN decoding with average performance is usually used to achieve an objective of a soft bit output. The following describes a BP soft bit decoding algorithm. FIG. 5 is a factor graph (factor graph) corresponding to a polar code with a code length N = 8. In FIG. 5, an end U is shown on the left, and an end X is shown on the right. The end U includes N bits in total: $U_1$, $U_2$, ..., and $U_N$. The end X includes N bits in total: $X_1$, $X_2$, ..., and $X_N$. $U_1^N$ is a signal before coding, and $X_1^N$ is a signal after coding. A relationship between $U_1^N$ and $X_1^N$ may be described as $X_1^N =$

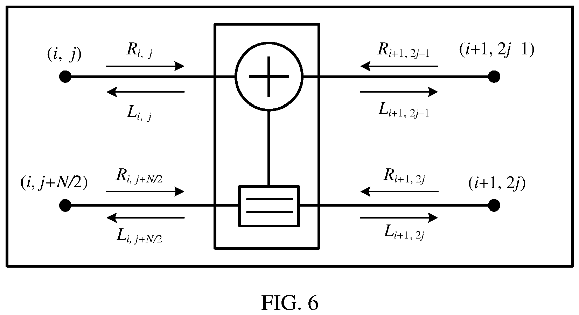

$U_1^N \times G_N$ , where $G_N$ is a polar code generator matrix, and corresponds to the factor graph in FIG. 5. A BP decoder first receives a signal $Y_1^N$ from a channel, calculates an initialized log-likelihood ratio (Logarithm Likelihood Ratio, LLR) of $X_1^N$ , and then updates the log-likelihood ratio layer by layer from the end X to the end U based on the factor graph. An update process is described by a 2x2 module (that is, a 2x2 factor graph) in a dashed box in FIG. 5. A calculation process is shown in FIG. 6, and specific formulas are as follows:

$$L_{i,j} = g\left(L_{i+1,2j-1}, L_{i+1,2j} + R_{i,j+\frac{N}{2}}\right) \text{ (formula 1)}$$

$$L_{i,j+N/2} = g\left(R_{i,j}, L_{i+1,2j-1}\right) + L_{i+1,2j} \text{ (formula 2)}$$

$$R_{i+1,2j-1} = g\left(R_{i,j}, L_{i+1,2j} + R_{i,j+\frac{N}{2}}\right) \text{ (formula 3)}$$

$$R_{i+1,2j} = g\left(R_{i,j}, L_{i+1,2j-1}\right) + R_{i,j+N/2} \text{ (formula 4)}$$

Herein,

$$g(x, y) = \ln((1 + xy)/(x + y)).$$

After the logarithm-likelihood ratio is updated from the end X to the end U, the update is performed from the end U to the end X based on settings of fixed bits and information bits, and the foregoing formula 1 to formula 4 are still used. In this way, reciprocating update ends after a specific quantity $I_{BP}$ of iteration times are reached, and final soft bit values of $U_1^N$ and $X_1^N$ are obtained. It can be learned that performance of BP soft bit decoding is average, a plurality of times of iterations (a typical value of $I_{BP}$ is 200) are required, and calculation complexity and storage complexity are relatively high.

A core idea of an existing SCAN soft bit decoding algorithm is similar to that of BP soft bit decoding, except that a process of updating a log-likelihood ratio is no longer calculating soft bit values of all nodes layer by layer, but calculating soft bit value of information bits at an end U in sequence by using a tree structure similar to SC decoding. Therefore, the algorithm has lower calculation and storage complexity than the BP decoding algorithm, but still requires repeated iterations, and has decoding performance similar to that of the BP decoding algorithm.

In this application, for a disadvantage of average performance of current polar soft bit decoding, it is proposed that a corresponding soft bit value is further extracted from a hard bit output obtained through decoding such as SCL or CA-SCL with better decoding performance, to achieve an effect of a soft bit output, so that a hard bit decoding manner with high performance is applicable to more application scenarios.

A CA-SCL decoding method is an enhancement of an SCL decoding method. A kernel of SCL decoding remains unchanged, but a CRC is added to an information bit before polar encoding. After a candidate path is obtained through the SCL decoding, a CRC check is performed to assist path selection, so that polar decoding performance is improved with relatively low complexity. The following describes an SCL hard bit decoding manner.

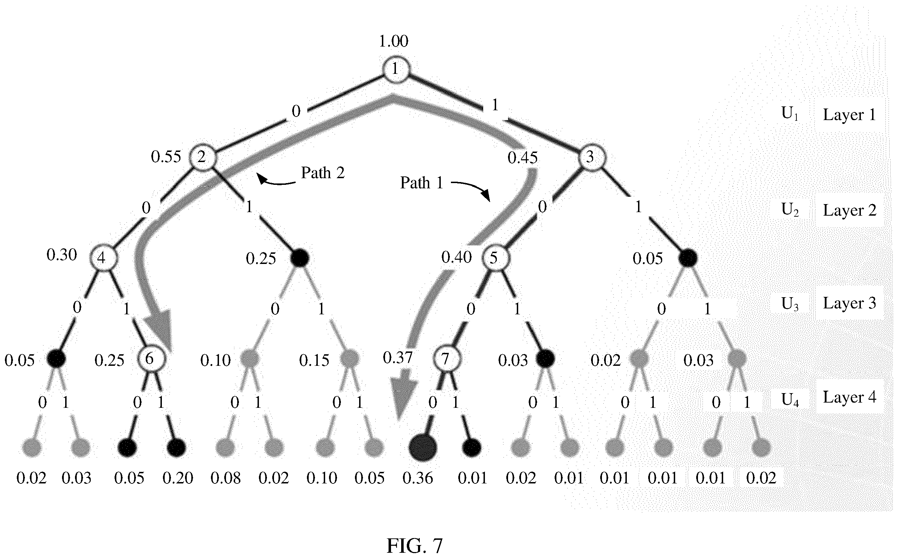

FIG. 7 is a schematic diagram of a tree structure of SCL decoding according to an embodiment of this application. After receiving a channel output signal $Y_1^N$ , an SCL decoder makes a bit-by-bit decision on a transmitted signal $U_1^N$ , that is, from $U_1$ to $U_N$. Each bit is represented by an $i^{th}$ layer, where $1 \leq i \leq N$. For $U_i$ at each layer, the SCL decoder separately performs probability calculation on $U_i$=0 and $U_i$=1 based on a previously decided bit $U_1^{i-1}$ . Therefore, as i increases, a quantity of obtained layers also increases continuously, and the tree structure in FIG. 7 is formed. Each path has a corresponding weight, and a value of the weight is determined by a probability of a corresponding value U on the path. The weight may be understood as a posterior probability value of a candidate sequence corresponding to a current candidate path. When a quantity of paths is greater than a specified value L, that is, a list list size limit value, L paths with largest weights are selected based on the weights of the paths. A path with a largest weight is selected from the L finally output paths, as a final output of the SCL decoder. A list list is a register for storing a candidate path during SCL decoding of a polar code, and includes L candidate path elements whose sizes are N. Because sequential decoding is used, decided bits of each candidate sequence are generated bit by bit from a number 1 to a number N, and then trimmed based on a weight value attached to each path, to finally obtain L candidate paths with relatively large weight values. As shown in FIG. 7, a bit sequence of a path 1 is 11000, a code length of the path 1 is 5, and a weight corresponding to the path 1 is 0.36. A bit sequence of a path 2 is 10011, a code length of the path 2 is 5, and a weight corresponding to the path 2 is 0.20.

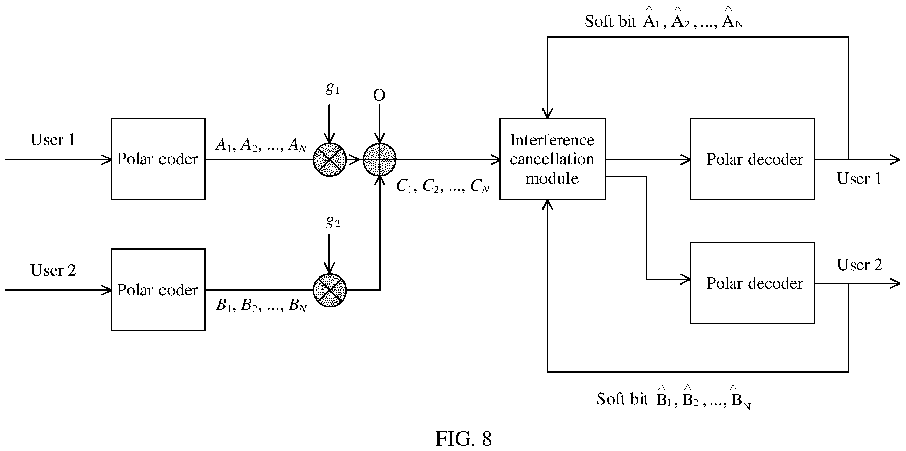

In this application, based on an SCL hard bit decoding manner, a soft bit that is required for decoding is obtained based on a hard bit obtained through SCL decoding, so that the SCL decoding manner is applicable to a scenario in which polar code soft bit iterative decoding needs to be used. The scenario in which polar code soft bit iterative decoding needs to be used may be, for example: when a polar code is concatenated with another decoding manner (for example, but not limited to, a low-density parity-check (Low-Density Parity-Check, LDPC) code or a turbo code), in order to match iterative decoding of the LDPC code or the turbo code, a polar code decoder needs to output a soft bit value. For another example, when a receive end performs interference cancellation between a plurality of users on a multiple access channel (Multiple Access Channel, MAC), a soft bit output of a polar code also needs to be used. A two-user MAC system is used as an example. For a schematic diagram of a receive-end interference cancellation decoding scheme in the two-user MAC communications system, refer to FIG. 8. Coded signals of a user 1 and a user 2 are respectively represented by $A_1^N$ and $B_1^N$, and a received signal $C_1^N$ is obtained after respective channel gains $g_1$ and $g_2$ and additive Gaussian noise O are performed on the coded signals. At the receive end, two polar decoders calculate soft bit values of signals sent by respective users, and feed back the soft bit values to an interference cancellation module to continuously perform iterative correction on decoding results, and output decoded signals $\widehat{A}_1^N$ and $\widehat{B}_1^N$ after a specific quantity of iteration times are reached. Therefore, both polar decoders in FIG. 8 need to output soft bits. A polar encoder in FIG. 8 may be an encoder of a terminal or an encoder of a network device. In a specific application, the encoder may be implemented by a processor of the terminal or the network device.

It should be noted that a scenario in which polar code soft bit iterative decoding needs to be used in this application includes but is not limited to the foregoing two scenarios.

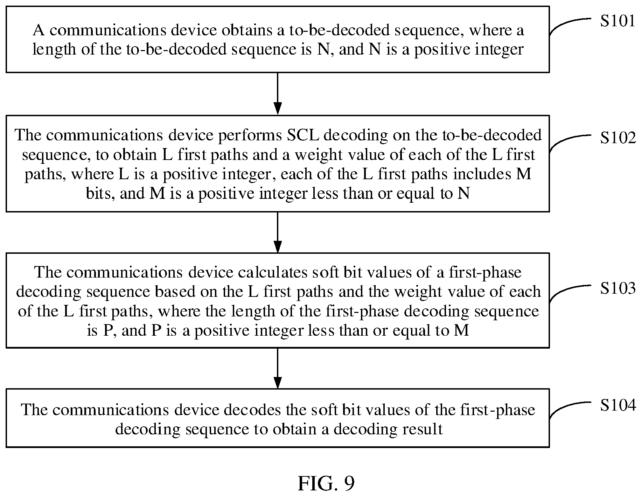

Based on the embodiments respectively corresponding to the communications system 100, the terminal device 200, and the network device 300, an embodiment of this application provides a polar polar code decoding method. Referring to FIG. 9, the polar polar code decoding method includes but is not limited to the following steps.

S101: Obtain a to-be-decoded sequence, where a length of the to-be-decoded sequence is N, and N is a positive integer.

In this embodiment of the present invention, the to-be-decoded sequence is the foregoing channel received signal $Y_1^N$, that is, a signal received by a communications device from a channel. A code length of the channel received signal $Y_1^N$ is N. In this embodiment of the present invention, the communications device may be a terminal or a chip of a terminal, or may be a network device or a chip of a network device.

S102: Perform SCL decoding on the to-be-decoded sequence, to obtain L first paths and a weight value of each of the L first paths, where L is a positive integer, each of the L first paths includes M bits, and M is a positive integer less than or equal to N.

S103: Calculate soft bit values of a first-phase decoding sequence based on the L first paths and the weight value of each of the L first paths, where the length of the first-phase decoding sequence is P, and P is a positive integer less than or equal to M.

In a first implementation, N=M=P, that is, code lengths of the to-be-decoded sequence $Y_1^N$, the first path, and the first-phase decoding sequence are all equal.

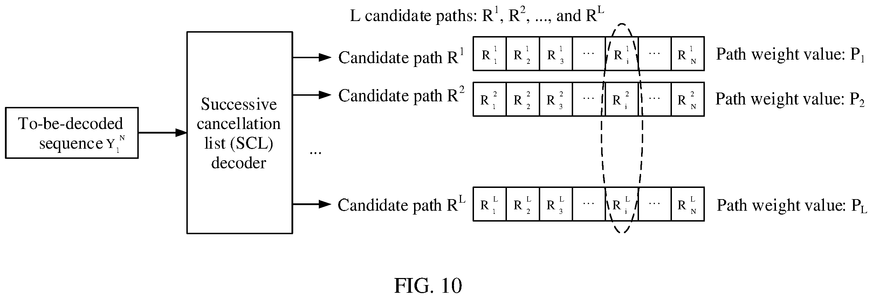

Specifically, the communications device performs polar code SCL decoding on the received signal $Y_1^N$ output by the channel to obtain L candidate decoding paths $R^1$, $R^2$, ..., and $R^L$, and a weight value P corresponding to each candidate path. Each candidate path has N bits Ri to $R_N$. For example, a candidate path $R^1$ includes N bits $R_1^1$ to $R_N^1$. L is a size of a list list in SCL decoding. Herein, the L candidate paths $R^1$, $R^2$, ..., and $R^L$ are the foregoing L first paths. For a schematic principle diagram of an SCL decoding method, refer to FIG. 10. An SCL decoder may be a decoder of the terminal or a decoder of the network device.

Then, soft bit values of bits at an end U are calculated based on the obtained L candidate decoding paths and the corresponding weight values of the L candidate decoding paths. Herein, the bits at the end U are the first-phase decoding sequence, and the soft bit values of the bits at the end U are the soft bit values of the first-phase decoding sequence. The soft bit values of the bits at the end U are denoted as $S(U_1, ..., U_N)$. $R_i^j$ is denoted as an $i^{th}$ bit in a $j^{th}$ candidate sequence $R^j$, where $1 \le i \le N$, and $1 \le j \le L$.

$P_j$ is denoted as a weight value of the candidate path j, for example, a posterior probability value corresponding to the candidate path j. $\mathcal{F}$ is denoted as a set of polar code fixed bits (Frozen bits), and $\mathcal{J}$ is denoted as a set of polar code information bits (Information bits). Therefore, a formula for calculating a soft bit value of an $i^{th}$ bit $U_i$ at the end U may be, for example, but is not limited to, the following formula 5:

$$\begin{cases} \text{if } i \in \mathcal{F}, S(U_i) = V \\ \text{if } i \in \mathcal{J}, \text{all } R_i^j = 0, S(U_i) = Y \\ \text{if } i \in \mathcal{J}, \text{all } R_i^j = 1, S(U_i) = Z \quad \text{(formula 5)} \\ \text{else}, S(U_i) = \ln \dfrac{\sum_j P_j \mathbb{1}\left(R_i^j = 0\right)}{\sum_j P_j \mathbb{1}\left(R_i^j = 1\right)} \end{cases}$$

In the foregoing formula 5, S represents the soft bit value. The formula 5 may be understood as follows: When the soft bit value of the $i^{th}$ bit $U_i$ is calculated (in a dashed-line ellipse in FIG. 10), if the $i^{th}$ bit is a fixed bit, a soft bit output of the $i^{th}$ bit is V. If the $i^{th}$ bit is an information bit and all $i^{th}$ bits in all the candidate paths are 0, a soft bit output of the $i^{th}$ bit is also Y. On the contrary, if the $i^{th}$ bit is an information bit and all bits in all the candidate paths are 1, a soft bit output of the $i^{th}$ bit is also Z. If the $i^{th}$ bit is an information bit, and not all bits in the candidate paths are 0 or 1, an output soft bit is a logarithmic ratio of weighted probabilities of the bits 0 and 1. In an actual application, V, Y, and Z each may be set to a relatively large log-likelihood ratio. Absolute values of V, Y, and Z may be equal or may not be equal. In addition, a product of V and Y is positive, and a product of V and Z is negative. In other words, if V is a positive number, Y is also a positive number, and Z is a negative number. For example, V and Y each may be set to 50, and Z may be set to -50.

In an implemetation, after the soft bit value of UN is obtained, a soft bit value of an end X, that is, the soft bit value of $X_1^N$, may be further calculated based on the soft bit value of $U_1^N$. Herein, bits at the end U are the first-stage decoding sequence, and soft bit values of the bits at the end X are the soft bit values of the second-stage decoding sequence.

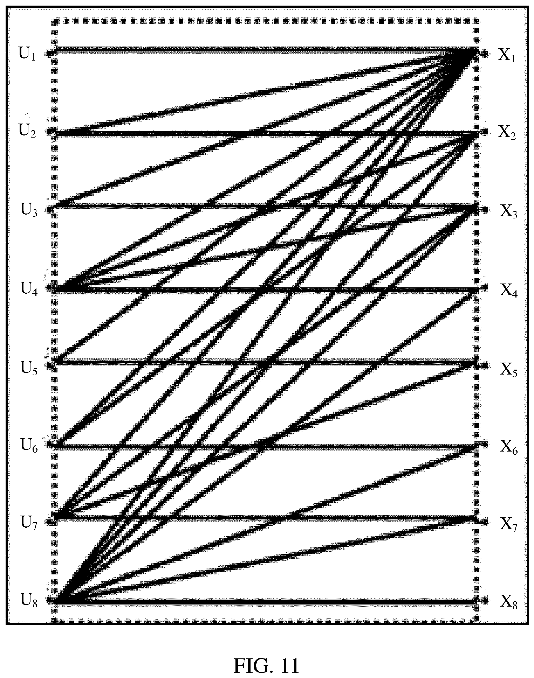

Optionally, a polar code BP soft bit decoding algorithm may be used, that is, soft bit values are calculated layer by layer from an end U to an end X based on the 2x2 factor graph (factor graph) of the polar code shown in FIG. 5 and FIG. 6. Optionally, the soft bit values at the end X may be directly reversely deduced based on an $N \times N$ factor graph, so that a layer-by-layer calculation process is omitted. Compared with the layer-by-layer calculation manner of the 2x2 factor graph, calculation efficiency of the manner of the NxN factor graph is higher. For example, N=8, and an 8x8 factor graph of $U_1^N$ and $X_1^N$ is shown in FIG. 11. A node connection relationship and a polar code generator matrix $G_N$ thereof are in a one-to-one correspondence. $g_{j,i}$ is denoted as an element in a $j^{th}$ row and an $i^{th}$ column in the generator matrix $G_N$, and a soft bit calculation formula of an $i^{th}$ coded bit $X_i$ is:

$$S(X_i) = 2\,\text{atanh}\left(\prod_{j:\, g_{j,i}=1}^{N} \tanh\left(\frac{S(U_j)}{2}\right)\right) \quad \text{(formula 6)}$$

The formula 6 may be understood as a confidence propagation formula at a check node, and is similar to a confidence propagation formula of an LDPC code. $U_j$ connected to the node $X_i$ corresponds to $g_{j,j} = 1$ in the generator matrix. Then, calculation is performed based on a formula $\tanh\left(\frac{V_{out}}{2}\right) = \prod \tanh\left(\frac{V_{in}}{2}\right)$, where $S(X_i)$ is equivalent to $V_{out}$, a soft bit value $S(U_j)$ corresponding to $U_j$ connected to the node $X_i$ is equivalent to $V_{in}$, and atanh() is an inverse function of tanh. Π represents multiplication.

In the foregoing first implementation, the soft bit values at the end U are first calculated, and then the soft bit values at the end X are calculated based on the factor graph of the polar code. In a second implementation, soft bit values of a bit sequence at the end X may be directly calculated. Herein, the bit sequence at the end X is the first-phase decoding sequence, and the soft bit values of the bit sequence at the end X are the soft bit values of the first-phase decoding sequence. In the second implementation, N=M=P, that is, code lengths of the to-be-decoded sequence $Y_1^N$, the first path, and the first-phase decoding sequence are all equal.

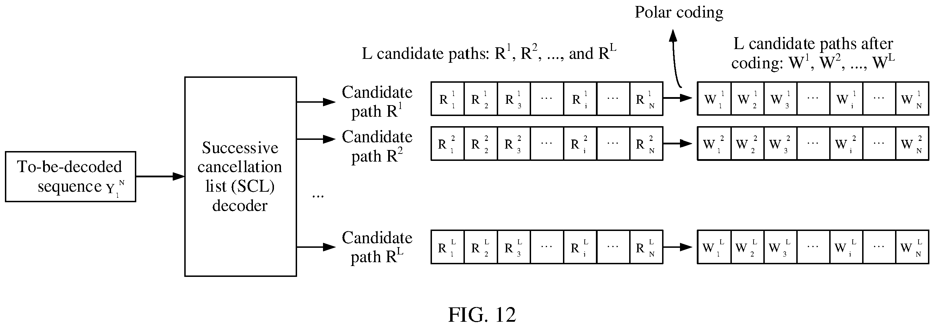

Specifically, after SCL decoding is performed on the polar code, polar encoding is performed on the obtained L candidate paths $R^1$, $R^2$, ..., and $R^L$ to obtain corresponding L candidate paths $W^1$, $W^2$, ..., and $W^L$. In the second implementation, the L candidate paths $R^1$, $R^2$, ..., and $R^L$ obtained through SCL decoding are second paths, and the L candidate paths $W^1$, $W^2$, ..., and $W^L$ obtained by coding the L candidate paths $R^1$, $R^2$, ..., and $R^L$ are the foregoing L first paths. Each candidate path W has N bits. For example, the first candidate path $W^1$ includes N bits $W_1^1$ to $W_N^1$. Then, a weight corresponding to each candidate path W is calculated based on a Euclidean distance between the candidate path W and the received signal $Y_1^N$, and finally, the soft bit values at the end X are calculated based on each candidate path W and the weight of the candidate path W. A schematic principle diagram of the method is shown in FIG. 12.

Because $G_N$ is a polar code generator matrix, the candidate path W may be calculated by using a relationship $W = R \times G_N$. For an $m^{th}$ ($1 \leq m \leq L$) candidate path $W^m$ in the L candidate paths $W^1$, $W^2$, ..., and $W^L$, a weight $P_m$ of the candidate path $W^m$ may be calculated based on a Euclidean distance between the candidate path $W^m$ and the received signal $Y_1^N$, that is, the following formula 7:

$$P_m = \ln(|W^m - Y_1^N|^2) \quad \text{(formula 7)}$$

$W^m$ is the $m^{th}$ candidate path.

$X_i$ is set as an $i^{th}$ coded bit at the end X, and $1 \leq i \leq N$. When a soft bit value of the $i^{th}$ bit $X_i$ is calculated, if an $i^{th}$ bit of each of the L candidate paths $W^1$, $W^2$, ..., and $W^L$ is 0, the soft bit value of $X_i$ is determined by using a minimum weight value of a path whose $i^{th}$ bit is 0 in the L candidate paths $W^1$, $W^2$, ..., and $W^L$. If $i^{th}$ bits of all the L candidate paths $W^1$, $W^2$, ..., and $W^L$ are 1, the soft bit value of $X_i$ is determined by using a minimum weight value of a path whose $i^{th}$ bit is 1 in the L candidate paths $W^1$, $W^2$, ..., and $W^L$. Otherwise, the soft bit value of the $i^{th}$ bit $X_i$ in the first-phase decoding sequence is determined by using a minimum weight value of a path whose $i^{th}$ bit is 0 in the L first paths $W^1$, $W^2$, ..., and $W^L$ and a minimum weight value of a path whose $i^{th}$ bit is 1 in the L first paths $W^1$, $W^2$, ..., and $W^L$.

In an optional implementation, $P_p$ is set as a minimum weight value corresponding to $X_i = 0$ in the L candidate paths $W^1$, $W^2$, ..., and $W^L$. $P_q$ is a minimum weight value corresponding to $X_i = 1$ in the L candidate paths $W^1$, $W^2$, ..., and $W^L$. In this case, a formula for calculating the soft bit value $S(X_i)$ of $X_i$ is as follows:

$$\begin{cases} \text{if } X_i = 0 \text{ for all path}, S(X_i) = C \times P_p \\ \text{if } X_i = 1 \text{ for all path}, S(X_i) = C \times P_q \quad \text{(formula 8)} \\ \qquad \text{else}, S(X_i) = P_p - P_q \end{cases}$$

In the foregoing formula 8, C is a fixed scaling factor (scaling factor). The formula 8 may be understood as follows: When the soft bit value of the $i^{th}$ bit $X_i$ is calculated, if the $i^{th}$ bit of each of the L candidate paths $W^1$, $W^2$, ..., and $W^L$ is 0, the soft bit value of $X_i$ is equal to a product of the minimum weight value $P_p$ of the path whose $i^{th}$ bit is 0 in the L candidate paths $W^1$, $W^2$, ..., and $W^L$ and a fixed parameter. If the $i^{th}$ bits of all the L candidate paths $W^1$, $W^2$, ..., and $W^L$ are 1, the soft bit value of $X_i$ is equal to a product of a minimum weight value $P_q$ of a path whose $i^{th}$ bit is 1 in the L candidate paths $W^1$, $W^2$, ..., and $W^L$ and a fixed parameter. Otherwise, the soft bit value of the $i^{th}$ bit $X_i$ in the first-phase decoding sequence is equal to a difference between $P_p$ and $P_q$. It should be noted that C may be a preset value.

Optionally, after the soft bit value at the end X is obtained, if the soft bit value of the end U needs to be obtained, $S(U_1^N)$ may be reversely deduced from $S(X_1^N)$ by using the factor graph of the polar code. For example, $S(U_1^N)$ may be reversely deduced from $S(X_1^N)$ by using the manner of the 2x2 factor graph or the NxN factor graph. Compared with the foregoing first implementation, in the second implementation, a process of layer-by-layer calculation when soft values are updated reversely from the end U to the end X is omitted. Therefore, the second implementation is simpler, and calculation efficiency is higher.

In the first implementation and the second implementation, if all information bits are 0 or 1, setting the soft bits to Y or Z causes an error. When the list is relatively large, such processing causes a relatively small error. When the list is relatively small, a backtracking method needs to be used for calculation, to prevent some paths from being discarded with a decoding process. In both the foregoing two implementations, the soft bit values are calculated after an SCL decoding process of the polar code ends. For SCL decoding, a candidate path is inevitably trimmed in a decoding process, and some paths may be discarded in the decoding process. Therefore, a final result of SCL decoding causes a performance loss when the soft bits are calculated, especially when a size of the list is small. In this case, the soft bit values may be calculated by using the following third implementation which is not part of the invention.

In a comparative example, M<N, and P<M. To be specific, the length of the first path is less than the length of the to-be-decoded sequence, and the length of the first-phase decoding sequence is less than the length of the first path.

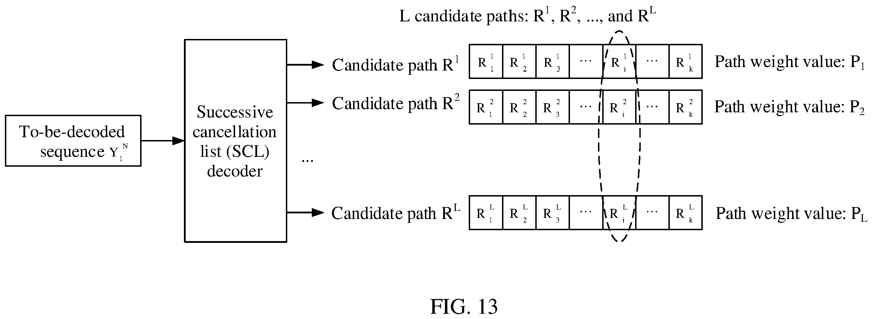

Specifically, a decoder of the communications device continuously traces back in an SCL decoding process, and calculates soft bit values as much as possible before a candidate path is trimmed, thereby improving accuracy. It is assumed that when the SCL decoding is performed on a $k_{th}$ bit, there are already L candidate paths $R^1$, ..., $R^L$ in a decoding pool. An arrow in FIG. 13 indicates a current decoding position of an SCL decoder. In this case, the soft bit value of the $i^{th}$ bit is retrospectively calculated. Optionally, $I = k - \log_2 L$. For example, L=32, and k=7. Calculation of soft bit values at the end U is used as an example. When the decoder decodes a seventh bit, a soft bit value of a first bit $U_l$ at the end U needs to be calculated. Because calculation is also performed on the end U, a calculation formula of the soft bit value $S(U_i)$ is consistent with the foregoing formula 5, and details are not described herein again. After the soft bit values at the end U are obtained, if the soft bit values at the end X are required, reverse update may be performed by using a 2x2 factor graph or an NxN factor graph, to obtain the soft bit values at the end X. If the soft bit values at the end X need to be directly calculated, reference may be made to a calculation process in the foregoing second implementation, and details are not described herein again.

S104: Decode the soft bit values of the first-phase decoding sequence to obtain a decoding result.

In this embodiment of the present invention, after obtaining the soft bit values of the first-phase decoding sequence, the communications device performs decoding based on the soft bit values of the first-phase decoding sequence, to finally obtain a decoding result.

The following describes in detail, with reference to two specific embodiments, a manner in which the communications device decodes the soft bit values of the first-phase decoding sequence to obtain the decoding result in step S104.

(1) Embodiment 1

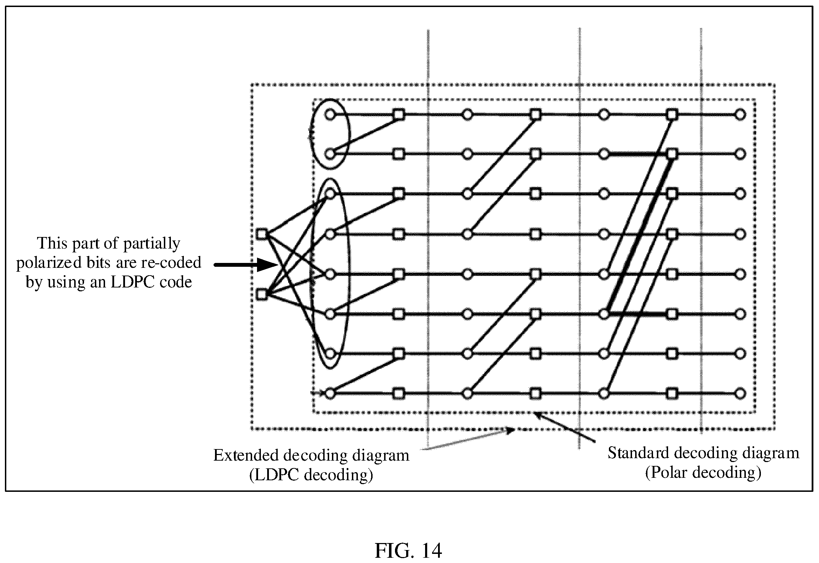

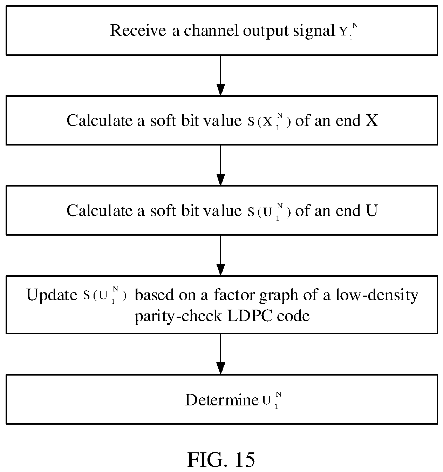

In Embodiment 1, in a single-user scenario, a polar code is concatenated with an LDPC code, a turbo code, or another coding scheme, to improve performance of the polar code. In a case of a limited code length, some channels that are not completely polarized still exist after a polar code channel polarization process. To improve decoding performance of the polar code, bits transmitted on the channels that are not completely polarized may be coded again. An LDPC code is used as an example, and bits that are not completely polarized may be re-coded by using the LDPC code. In other words, a coding scheme in which a polar code and an LDPC code are concatenated is constructed. The LDCP code is an inner code, and the polar code is an outer code. A schematic diagram of decoding corresponding to the concatenated coding scheme is shown in FIG. 14. FIG. 14 shows that because a soft bit decoding method is usually used for the LDPC code, a polar decoder is required to output soft bits for matching, so that extended decoding can be performed based on an original factor graph of the polar code. A flowchart of the extended decoding algorithm is shown in FIG. 15. After the channel output signal $Y_1^N$ is received, the soft bit value $S(X_1^N)$ at the end X is first initialized. Then, the soft bit value $S(U_1^N)$ at the end U is calculated by using the soft bit decoding scheme of the polar code described in the foregoing implementation. For example, the soft bit values at the end U are calculated reversely and iteratively in the manner of the 2x2 factor graph by using the soft bit values at the end X. Then, $S(U_1^N)$ is updated based on connection information of a variable node and a check node of the LDPC code, that is, based on a factor graph of the LDPC code. The soft bit values at the end X are then calculated iteratively by using the soft bit values at the end U in the manner of the 2x2 factor graph, and $U_1^N$ is finally determined after a plurality of repeated iterations. An implementation of updating $S(U_1^N)$ based on the factor graph of the LDPC code belongs to the prior art, and details are not described in this application. That is, determining $U_1^N$ means determining, based on the soft bit value of $U_1^N$, whether each bit in $U_1^N$ is 0 or 1.

In an existing concatenated scheme, polar BP decoding is mainly used to implement a soft bit output. In comparison, an SCL-based soft decoding algorithm used in Embodiment 1 has better performance, and does not require a BP iteration of a polar code. Therefore, a system design is simpler, and the algorithm is more efficient.

(2) Embodiment 2

In Embodiment 2, a polar code soft bit decoding scheme is applied to an application scenario in which interference cancellation is performed in a two-user MAC system. A block diagram of the system is shown in FIG. 8. Coding signals of a user 1 and a user 2 are respectively represented by $A_1^N$ and $B_1^N$, and a received signal $C_1^N$ is obtained after respective channel gains $g_1$ and $g_2$ and additive Gaussian noise are performed on the coded signals. At a receive end, two polar decoders calculate soft bit values of signals sent by respective users, and feed back the soft bit values to an interference cancellation module to continuously perform iterative correction on decoding results, and output decoded signals $\widehat{A}_1^N$ and $\widehat{B}_1^N$ after a specific quantity of iteration times are reached.

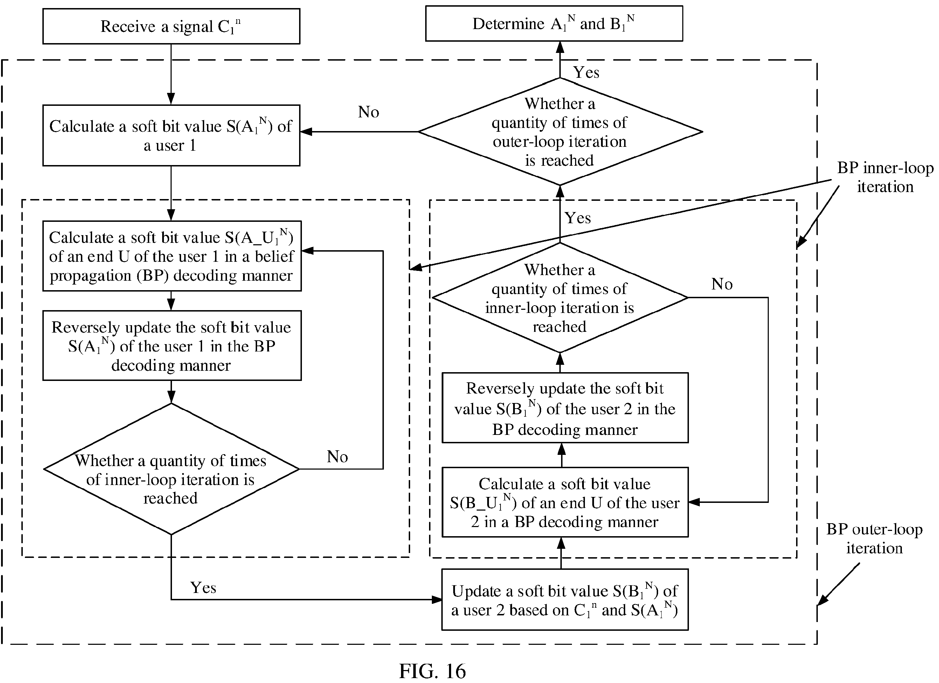

If a conventional polar code soft bit decoding method is used, a BP algorithm is used as an example. A procedure of an interference cancellation algorithm is shown in FIG. 16. At the receive end, an initial soft bit value $S(A_1^N)$ of the user 1 is first calculated based on the received signal $C_1^N$. Then, a soft bit value $S(A\_U_1^N)$ at an end U of the user 1 is calculated based on a BP decoding algorithm, and $S(A_1^N)$ is repeatedly updated. This process is a standard polar code BP decoding process, also referred to as an inner loop iteration, and is marked by a dashed box in FIG. 16. After the inner loop iteration is completed, a soft bit value $S(B_1^N)$ of the user 2 is calculated based on $C_1^N$ and a latest $S(A_1^N)$. Similarly, a BP decoding inner-loop iteration is performed on a polar code of the user 2, and after the BP decoding inner-loop iteration ends, the soft bit value $S(A_1^N)$ of the user 1 is updated, and then an outer-loop iteration process is repeated, as shown in a dashed box in FIG. 16. Two BP inner-loop iteration modules are only for different users, and algorithm procedures of the two BP inner-loop iteration modules are consistent with each other.

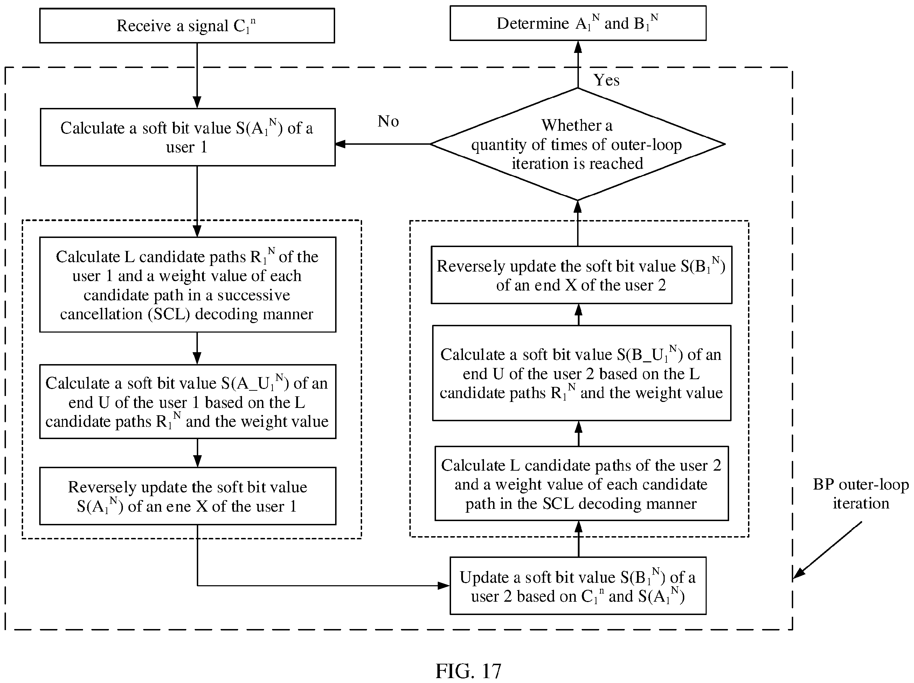

According to a soft bit output scheme based on SCL decoding provided in this application, an iterative interference cancellation decoding algorithm is simplified, as shown in a flowchart in FIG. 17. A difference from FIG. 16 lies in that a BP inner-loop iteration process is replaced with the soft bit output scheme provided in the present invention. In FIG. 17, a soft bit calculation method in the foregoing first implementation is used as an example. In this embodiment of the present invention, L candidate paths of the user 1 and a weight value of each of the L candidate paths are first obtained in an SCL decoding manner. The soft bit value $S(A\_U_1^N)$ at the end U of the user 1 is calculated based on the obtained weight value of each of the L candidate paths. Then, the soft bit value $S(A_1^N)$ at the end X of the user 1 is calculated through reverse update of the soft bit values at the end U by using the BP 2x2 factor graph or the NxN factor graph. Then, the soft bit value $S(B_1^N)$ of the user 2 is calculated based on $C_1^N$ and the latest $S(A_1^N)$. Similarly, for the user 2, the L candidate paths of the user 2 and the weight value of each of the L candidate paths are obtained in the SCL decoding manner. The soft bit value $S(B\_U_1^N)$ at the end U of the user 2 is calculated based on the obtained weight value of each of the L candidate paths. Then, the soft bit value $S(B_1^N)$ at the end X of the user 2 is reversely updated based on the soft bit values at the end U by using the manner of the foregoing BP 2x2 factor graph or NxN factor graph. Then, the outer-loop iteration process is repeated.

In an existing interference cancellation scheme, polar code BP decoding is mainly used to implement a soft bit output, and then an outer-loop iteration is performed. In comparison, an SCL-based soft decoding algorithm used in Embodiment 2 of the present invention has better performance, and does not require BP iteration of a polar code. Therefore, a system design is simpler, and the algorithm is more efficient.

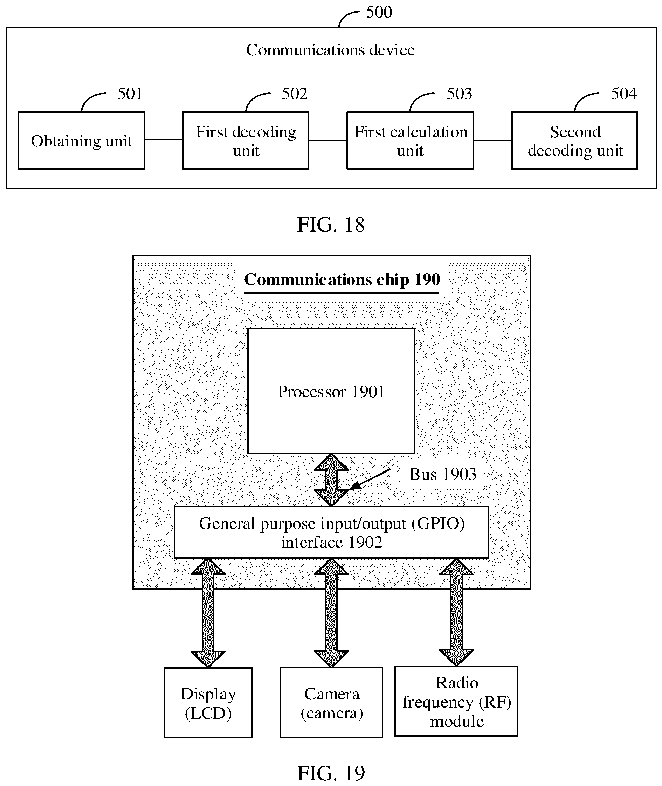

FIG. 18 is a functional block diagram of a communications device according to an embodiment of this application.

The communications device may be the network device 101 or the terminal device 102 in the embodiment of FIG. 1. Descriptions are provided separately below.

As shown in FIG. 18, a communications device 500 may include an obtaining unit 501, a first decoding unit 502, a first calculation unit 503, and a second decoding unit 504.

The obtaining unit 501 is configured to obtain a to-be-decoded sequence, where the length of the to-be-decoded sequence is N, and N is a positive integer.

The first decoding unit 502 is configured to perform SC-list decoding on the to-be-decoded sequence, to obtain L first paths and a weight value of each of the L first paths, where L is a positive integer, each of the L first paths includes M bits, and M is a positive integer less than or equal to N.

The first calculation unit 503 is configured to calculate soft bit values of a first-phase decoding sequence based on the L first paths and the weight value of each of the L first paths, where a length of the first-phase decoding sequence is P, and P is a positive integer less than or equal to M.

The second decoding unit 504 is configured to decode the soft bit values of the first-phase decoding sequence to obtain a decoding result.

Optionally, an $i^{th}$ bit in the first-phase decoding sequence is $U_i$, and $1 \leq i \leq P$.

If the $i^{th}$ bit $U_i$ in the first-phase decoding sequence is a fixed bit, a soft bit value of the $i^{th}$ bit $U_i$ in the first-phase decoding sequence is a first preset value.

If the $i^{th}$ bit $U_i$ in the first-phase decoding sequence is an information bit, and all $i^{th}$ bits of all the L first paths are 0, a soft bit value of the $i^{th}$ bit $U_i$ in the first-phase decoding sequence is a second preset value, where a product of the second preset value and the first preset value is a positive number.

If the $i^{th}$ bit $U_i$ in the first-phase decoding sequence is an information bit, and all $i^{th}$ bits of all the L first paths are 1, a soft bit value of the $i^{th}$ bit $U_i$ in the first-phase decoding sequence is a third preset value, where a product of the third preset value and the second preset value is a negative number.

If the $i^{th}$ bit $U_i$ in the first-phase decoding sequence is an information bit, and not all $i^{th}$ bits of the L first paths are 0 or 1, a soft bit value of the $i^{th}$ bit $U_i$ in the first-phase decoding sequence is determined by using a weight value of a path whose $i^{th}$ bit is 0 in the L first paths and a weight value of a path whose $i^{th}$ bit is 1 in the L first paths.

Optionally, if the $i^{th}$ bit $U_i$ in the first-phase decoding sequence is an information bit, and not all the $i^{th}$ bits of the L first paths are 0 or 1, the soft bit value of the $i^{th}$ bit $U_i$ in the first-phase decoding sequence is equal to a logarithm of a ratio of a first weight value to a second weight value, the first weight value is a sum of weight values of paths whose $i^{th}$ bits are 0 in the L first paths, and the second weight value is a sum of weight values of paths whose $i^{th}$ bits are 1 in the L first paths.

According to an embodiment, N=M=P; and the communications device 500 further includes:

a third decoding unit 503, configured to: after the first calculation unit calculates the soft bit values of the first-phase decoding sequence based on the L first paths and the weight value of each of the L first paths, perform soft bit iterative decoding on the soft bit values of the first-phase decoding sequence to obtain soft bit values of a second-stage decoding sequence, where a length of the second-stage decoding sequence is N.

Optionally, the third decoding unit is specifically configured to:

perform a 2x2 factor graph soft bit iterative decoding layer by layer on the soft bit values of the first-phase decoding sequence to obtain the soft bit values of the second-phase decoding sequence; or
perform NxN factor graph soft bit iterative decoding on the soft bit values of the first-phase decoding sequence to obtain the soft bit values of the second-phase decoding sequence.

According to an embodiment, N=M=P; and the first decoding unit 502 includes:

a fourth decoding unit, configured to perform SC-list decoding on the to-be-decoded sequence, to obtain L second paths, where each of the second paths includes N bits;
a coding unit, configured to perform polar coding on each of the L second paths to obtain the L first paths; and
a second calculation unit, configured to calculate the weight value of each of the L first paths based on a Euclidean distance between each of the L first paths and the to-be-decoded sequence.

Optionally, the second calculation unit is specifically configured to:

calculate the weight value of each of the L first paths based on the following formula where the formula is:

$$P_m = \ln(|W^m - Y_1^N|^2),$$

$P_m$ is a weight value of an $m^{th}$ path in the L first paths, $Y_1^N$ is the to-be-decoded sequence, $W^m$ is the $m^{th}$ path in the L first paths, $\left| W^m - Y_1^N \right|^2$ is a Euclidean distance between the $m^{th}$ path and the to-be-decoded sequence, and $1 \leq m \leq L$.

Optionally, the $i^{th}$ bit in the first-phase decoding sequence is Xi, and $1 \leq i \leq N$.

If the $i^{th}$ bits of the L first paths are all 0, a soft bit value of the $i^{th}$ bit $X_i$ in the first-phase decoding sequence is determined by using a minimum weight value of a path whose $i^{th}$ bit is 0 in the L first paths, where $1 \leq i \leq N$.

If the $i^{th}$ bits of the L first paths are all 1, a soft bit value of the $i^{th}$ bit $X_i$ in the first-phase decoding sequence is determined by using a minimum weight value of a path whose $i^{th}$ bit is 1 in the L first paths.

Otherwise, a soft bit value of the $i^{th}$ bit $X_i$ in the first-phase decoding sequence is determined by using a minimum weight value of a path whose $i^{th}$ bit is 0 in the L first paths and a minimum weight value of a path whose $i^{th}$ bit is 1 in the L first paths.

Optionally, if the $i^{th}$ bits of the L first paths are all 0, the soft bit value of the $i^{th}$ bit $X_i$ in the first-phase decoding sequence is equal to a product of a fourth preset value and a minimum weight value of a path whose $i^{th}$ bit is 0 in the L first paths.

If all the $i^{th}$ bits of the L first paths are 1, the soft bit value of the $i^{th}$ bit $U_i$ in the first-phase decoding sequence is equal to a product of a fifth preset value and a minimum weight value of a path whose $i^{th}$ bit is 1 in the L first paths.

Otherwise, the soft bit value of the $i^{th}$ bit $U_i$ in the first-phase decoding sequence is equal to a difference between a minimum weight value among weight values of paths whose $i^{th}$ bits are 0 in the L first paths and a minimum weight value of paths whose $i^{th}$ bits are 1 in the L first paths.

It can be understood that for specific implementation of functional units included in the first communications device 500, refer to the foregoing embodiments, and details are not described herein again.

FIG. 19 is a schematic structural diagram of a communications chip provided in this application. As shown in FIG. 19, a communications chip 190 may include a processor 1901 and one or more interfaces 1902 coupled to the processor 1901.

The processor 1901 may be configured to read and execute a computer-readable instruction. In a specific implementation, the processor 1901 may mainly include a controller, an arithmetic unit, and a register. The controller is mainly responsible for decoding an instruction, and sends a control signal to an operation corresponding to the instruction. The arithmetic unit is mainly responsible for performing a fixed-point or floating-point arithmetic operation, a shift operation, a logic operation, and the like, and may also perform an address operation and an address conversion. The register is mainly responsible for saving a number of register operations temporarily stored during instruction execution, intermediate operation results, and the like. In specific implementation, a hardware architecture of the processor 1901 may be an application-specific integrated circuit (Application Specific Integrated Circuits, ASIC) architecture, an MIPS architecture, an ARM architecture, an NP architecture, or the like. The processor 1901 may have a single core or a plurality of cores.

The interface 1902 may be configured to input to-be-processed data to the processor 1901, and may output a processing result of the processor 1901. In specific implementation, the interface 1902 may be a general purpose input output (General Purpose Input Output, GPIO) interface, and may be connected to a plurality of peripheral devices (such as a display (LCD), a camera (camera), and a radio frequency (Radio Frequency, RF) module). The interface 1902 is connected to the processor 1901 by using the bus 1903.

In this application, the processor 1901 may be configured to invoke, from a memory, a program for implementing, on a communications device side, a polar polar code decoding method provided in one or more embodiments of this application, and execute an instruction included in the program. The memory may be integrated with the processor 1901, or may be coupled to the communications chip 190 by using the interface 1902. The interface 1902 may be configured to output an execution result of the processor 1901. In this application, the interface 1902 may be specifically configured to output a decoding result of the processor 1901. For the polar polar code decoding method provided in one or more embodiments of this application, refer to the foregoing embodiments. Details are not described herein again.

It should be noted that a function corresponding to each of the processor 1901 and the interface 1902 may be implemented by using a hardware design, or may be implemented by using a software design, or may be implemented by combining software and hardware. This is not limited herein.

In the specification, claims, and accompanying drawings of this application, the terms "first", "second", "third", "fourth" and so on are intended to distinguish between different objects but do not indicate a particular order. In addition, the terms "including", "having", or any other variant thereof, are intended to cover non-exclusive inclusion. For example, a process, a method, a system, a product, or a device that includes a series of steps or units is not limited to the listed steps or units, but optionally further includes an unlisted step or unit, or optionally further includes another inherent step or unit of the process, the method, the product, or the device.

All or some of the foregoing embodiments may be implemented by using software, hardware, firmware, or any combination thereof. When software is used to implement the embodiments, the embodiments may be implemented completely or partially in a form of a computer program product. The computer program product includes one or more computer instructions. When the computer program instructions are loaded and executed on the computer, the procedure or functions according to the embodiments of this application are all or partially generated. The computer may be a general-purpose computer, a dedicated computer, a computer network, or other programmable apparatuses. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid-state drive (Solid State Disk, SSD)), or the like.

A person of ordinary skill in the art may understand that all or some of the processes of the methods in the embodiments may be implemented by a computer program instructing relevant hardware. The program may be stored in a computer-readable storage medium. When the program runs, the processes of the methods in the embodiments are performed. The foregoing storage medium may include: a magnetic disk, an optical disc, a read-only memory (Read-Only Memory, ROM), or a random access memory (Random Access Memory, RAM).

In the foregoing specific implementations, the objectives, technical solutions, and benefits of the subject-matter specified in the claims are further described in detail. It should be understood that the foregoing descriptions are merely specific implementations of embodiments of the present invention, but are not intended to limit the protection scope defined by the claims.

**Claims**

1. A polar code decoding method, comprising:

   obtaining (S101), a to-be-decoded sequence by receiving by a receiving device a channel output signal from a channel, wherein a coded signal is sent by a sending apparatus through the channel, wherein the coded signal is obtained, by the sending apparatus, by source coding and channel coding on a to-be-sent signal and rate matching and digital modulation on the coded signal, wherein the to-be-sent signal is a signal before coding and includes a fixed bit and an information bit, wherein a length of the to-be-decoded sequence is N, and N is a positive integer;
   performing, by the receiving apparatus, digital demodulation and de-rate matching;
   and performing, by the receiving apparatus, channel decoding, and source decoding, and finally restoring the signal by: obtaining L first paths and a weight value of each of the L first paths, wherein L is a positive integer, each of the L first paths comprises M bits, and M is a positive integer less than or equal to N;
   calculating (S103) soft bit values of a first-phase decoding sequence based on the L first paths and the weight value of each of the L first paths, wherein a length of the first-phase decoding sequence is P, and P is a positive integer less than or equal to M, wherein either the soft bit values of the signal before coding are first calculated, and then the soft bit values of the signal after coding are calculated based on a factor graph of the polar code, or, soft bit values of the signal after coding are directly calculated; and
   decoding (S104) the soft bit values of the first-phase decoding sequence to obtain a decoding result;
   **characterized in that**
   N=M=P; and, Case A, the soft bit values of the signal before coding are first calculated, and then the soft bit values of the signal after coding are calculated based on a factor graph of the polar code, wherein successive cancellation-list SC-list decoding is performed on the to-be-decoded sequence to obtain the L first paths and the weight value of each of the L first paths, and

   after the calculating the soft bit values of the signal before coding, the method further comprises:

   calculating the soft bit values of the signal after coding based on a factor graph of the polar code by performing soft bit iterative decoding on the soft bit values of the first-phase decoding sequence to obtain soft bit values of a second-stage decoding sequence, wherein a length of the second-stage decoding sequence is N and the soft bit values of a second-stage decoding sequence are the soft bit values of the coded signal;
   or, Case B, the soft bit values of the signal after coding are directly calculated, and the L first paths and the weight value of each of the L first paths are obtained by:

performing SC-list decoding on the to-be-decoded sequence, to obtain L second paths, wherein each of the second paths comprises N bits;
performing polar coding on each of the L second paths to obtain the L first paths; and
calculating a weight value of each of the L first paths based on a Euclidean distance between each of the L second paths and the to-be-decoded sequence.

2. The method according to Case A of claim 1, wherein the performing soft bit iterative decoding on the soft bit values of the first-phase decoding sequence to obtain soft bit values of a second-stage decoding sequence comprises:

performing a 2x2 factor graph factor graph soft bit iterative decoding layer by layer on the soft bit values of the first-phase decoding sequence to obtain the soft bit values of the second-phase decoding sequence; or
performing NxN factor graph factor graph soft bit iterative decoding on the soft bit values of the first-phase decoding sequence to obtain the soft bit values of the second-phase decoding sequence.

3. The method according to Case B of claim 1, wherein the calculating the weight value of each of the L first paths based on a Euclidean distance between each of the L first paths and the to-be-decoded sequence comprises:

calculating the weight value of each of the L first paths based on the following formula, wherein the formula is:

$$P_m = \ln(|W^m - Y_1^N|^2),$$

$P_m$ is a weight value of an $m^{th}$ path in the L first paths, $Y_1^N$ is the to-be-decoded sequence, $W^m$ is the $m^{th}$ path in the L first paths, $|W^m - Y_1^N|^2$ is a Euclidean distance between the $m^{th}$ path and the to-be-decoded sequence, and $1 \le m \le L$.

4. The method according to Case B of claim 2 or 3, wherein an $i^{th}$ bit in the first-phase decoding sequence is $X_i$, and $1 \le i \le N$;

if the $i^{th}$ bits of the L first paths are all 0, a soft bit value of the $i^{th}$ bit $X_i$ in the first-phase decoding sequence is determined by using a minimum weight value of a path whose $i^{th}$ bit is 0 in the L first paths, wherein $1 \le i \le N$;
if the $i^{th}$ bits of the L first paths are all 1, a soft bit value of the $i^{th}$ bit $X_i$ in the first-phase decoding sequence is determined by using a minimum weight value of a path whose $i^{th}$ bit is 1 in the L first paths; or
otherwise, a soft bit value of the $i^{th}$ bit $X_i$ in the first-phase decoding sequence is determined by using a minimum weight value of a path whose $i^{th}$ bit is 0 in the L first paths and a minimum weight value of a path whose $i^{th}$ bit is 1 in the L first paths.

5. The method according to claim 4, wherein if the $i^{th}$ bits of the L first paths are all 0, the soft bit value of the $i^{th}$ bit $X_i$ in the first-phase decoding sequence is equal to a product of a fourth preset value and a minimum weight value of a path whose $i^{th}$ bit is 0 in the L first paths;

if all the $i^{th}$ bits of the L first paths are 1, the soft bit value of the $i^{th}$ bit $U_i$ in the first-phase decoding sequence is equal to a product of a fifth preset value and a minimum weight value of a path whose $i^{th}$ bit is 1 in the L first paths; or
otherwise, the soft bit value of the $i^{th}$ bit $U_i$ in the first-phase decoding sequence is equal to a difference between a minimum weight value among weight values of paths whose $i^{th}$ bits are 0 in the L first paths and a minimum weight value of paths whose $i^{th}$ bits are 1 in the L first paths.

6. An apparatus configured to implement the method in accordance with any of claims 1 to 5.

7. An apparatus according to claim 6 implemented as a communications device (500), comprising:

an obtaining unit (501), configured to obtain a to-be-decoded sequence by receiving a channel output signal from a channel, wherein a coded signal is sent through the channel, wherein the coded signal is obtained, by a sending apparatus, by source coding and channel coding on a to-be-sent signal and rate matching and digital modulation on the coded signal, wherein the to-be-sent signal is a signal before coding and includes a fixed bit and an information bit, wherein the length of the to-be-decoded sequence is N, and N is a positive integer; wherein the communications device is configured for digital demodulation and derate matching channel decoding, and source decoding, and finally restoring the signal; wherein the communications device further comprises: a first decoding unit (502), configured to obtain L first paths and a weight value of each of the L first paths, wherein L is a positive integer, each of the L first paths comprises M bits, and M is a positive integer less than or equal to N;

a first calculation unit (503), configured to calculate soft bit values of a first-phase decoding sequence based on the L first paths and the weight value of each of the L first paths, wherein a length of the first-phase decoding sequence is P, and P is a positive integer less than or equal to M; wherein either the soft bit values of the signal before coding are first calculated, and then the soft bit values of the signal after coding are calculated based on a factor graph of the polar code, or, soft bit values of the signal after coding are directly calculated; and

a second decoding unit (504), configured to decode the soft bit values of the first-phase decoding sequence to obtain a decoding result;

**characterized in that**

N=M=P; and, Case A, the soft bit values of the signal before coding are first calculated, and then the soft bit values of the signal after coding are calculated based on a factor graph of the polar code, the first decoding unit (502) is configured to obtain the L first paths and the weight value of each of the L first paths by successive cancellation-list SC-list decoding, and after the calculating the soft bit values of the signal before coding, the first calculation unit (503) is further configured to:

calculate the soft bit values of the coded signal by performing soft bit iterative decoding on the soft bit values of the first-phase decoding sequence to obtain soft bit values of a second-stage decoding sequence, wherein a length of the second-stage decoding sequence is N and the soft bit values of a second-stage decoding sequence are the soft bit values of the coded signal;

or, Case B, the soft bit values of the signal after coding are directly calculated, and the first decoding unit (502) is configured to obtain the L first paths and the weight value of each of the L first paths by:

performing SC-list decoding on the to-be-decoded sequence, to obtain L second paths, wherein each of the second paths comprises N bits;

performing polar coding on each of the L second paths to obtain the L first paths; and

calculating a weight value of each of the L first paths based on a Euclidean distance between each of the L second paths and the to-be-decoded sequence.

8. A computer-readable storage medium, wherein the computer-readable storage medium stores a computer program, and when the computer program is executed by a processor, the method according to any one of claims 1 to 5 is implemented.

9. A computer program product, wherein when the computer program product is run on a computer, the computer is enabled to perform the method according to any one of claims 1 to 5.

10. A communications chip (190), comprising a processor (1901) and one or more interfaces coupled to the processor (1901), wherein the processor (1901) is configured to invoke program code from a memory to perform the method according to any one of claims 1 to 5, and the interface is configured to output a processing result of the processor (1901).

**Patentansprüche**

1. Polarcode-Decodierungsverfahren, umfassend:

Erhalten (S101) einer zu decodierenden Sequenz durch Empfangen eines Kanalausgangssignals von einem Kanal durch eine Empfangsvorrichtung, wobei ein codiertes Signal durch eine Sendeeinrichtung über den Kanal gesendet wird, wobei das codierte Signal durch die Sendeeinrichtung durch Quellencodierung und Kanalcodierung eines zu sendenden Signals und durch Ratenanpassung und digitale Modulation des codierten Signals erhalten wird, wobei das zu sendende Signal ein Signal vor der Codierung ist und ein festes Bit und ein Informationsbit enthält, wobei eine Länge der zu decodierenden Sequenz N ist und N eine positive ganze Zahl ist;

Durchführen, durch die Empfangseinrichtung, einer digitalen Demodulation und Ratenrückanpassung ("Derate-Matching");

und Durchführen, durch die Empfangseinrichtung, von Kanaldecodierung und Quellendecodierung und schließlich Wiederherstellen des Signals durch: Erhalten von L ersten Pfaden und eines Gewichtswertes für jeden der L ersten Pfade, wobei L eine positive ganze Zahl ist, jeder der L ersten Pfade M Bits umfasst und M eine positive ganze Zahl kleiner oder gleich N ist;

Berechnen (S103) von Softbit-Werten einer Decodiersequenz einer ersten Phase basierend auf den L ersten Pfaden und dem Gewichtswert jedes der L ersten Pfade, wobei eine Länge der Decodiersequenz der ersten Phase P ist und P eine positive ganze Zahl kleiner oder gleich M ist, wobei entweder die Softbit-Werte des Signals vor der Codierung zuerst berechnet werden und dann die Softbit-Werte des Signals nach der Codierung basierend auf einem Faktorgraphen des Polarcodes berechnet werden, oder Softbit-Werte des Signals nach der Codierung direkt berechnet werden; und

Decodieren (S104) der Softbit-Werte der Decodiersequenz der ersten Phase, um ein Decodierergebnis zu erhalten;

**dadurch gekennzeichnet, dass**

N=M=P ist; und, Fall A, die Softbit-Werte des Signals vor der Codierung zuerst berechnet werden und dann die Softbit-Werte des Signals nach der Codierung basierend auf einem Faktorgraphen des Polarcodes berechnet werden, wobei eine sukzessive Löschungslisten/SC-Listen-Decodierung an der zu decodierenden Sequenz durchgeführt wird, um die L ersten Pfade und den Gewichtswert jedes der L ersten Pfade zu erhalten, und nach dem Berechnen der Softbit-Werte des Signals vor der Codierung das Verfahren ferner umfasst:

Berechnen der Softbit-Werte des Signals nach der Codierung basierend auf einem Faktorgraphen des Polarcodes durch Ausführen einer iterativen Softbit-Decodierung an den Softbit-Werten der Decodiersequenz der ersten Phase, um Softbit-Werte einer Decodiersequenz einer zweiten Stufe zu erhalten, wobei eine Länge der Decodiersequenz der zweiten Stufe N ist und die Softbit-Werte einer Decodiersequenz der zweiten Stufe die Softbit-Werte des codierten Signals sind;

oder, Fall B, die Softbit-Werte des Signals nach der Codierung direkt berechnet werden und die L ersten Pfade und der Gewichtswert jedes der L ersten Pfade erhalten werden durch:

Durchführen einer SC-Listen-Decodierung an der zu decodierenden Sequenz, um L zweite Pfade zu erhalten, wobei jeder der zweiten Pfade N Bits umfasst;

Durchführen einer Polarcodierung auf jedem der L zweiten Pfade, um die L ersten Pfade zu erhalten; und

Berechnen eines Gewichtswertes für jeden der L ersten Pfade basierend auf einem euklidischen Abstand zwischen jedem der L zweiten Pfade und der zu decodierenden Sequenz.

2. Verfahren gemäß Fall A aus Anspruch 1, wobei das Durchführen der iterativen Softbit-Decodierung an den Softbit-Werten der Decodiersequenz der ersten Phase, um Softbit-Werte einer Decodiersequenz der zweiten Stufe zu erhalten, umfasst:

Durchführen einer schichtweisen iterativen 2x2-Faktorgraph/Faktorgraph-Softbit-Decodierung an den Softbit-Werten der Decodiersequenz der ersten Phase, um die Softbit-Werte der Decodiersequenz der zweiten Phase zu erhalten; oder

Durchführen einer iterativen NxN-Faktorgraph/Faktorgraph-Softbit-Decodierung an den Softbit-Werten der Decodiersequenz der ersten Phase, um die Softbit-Werte der Decodiersequenz der zweiten Phase zu erhalten.

3. Verfahren gemäß Fall B aus Anspruch 1, wobei das Berechnen des Gewichtswertes für jeden der L ersten Pfade basierend auf einem euklidischen Abstand zwischen jedem der L ersten Pfade und der zu decodierenden Sequenz umfasst:

Berechnen des Gewichtswertes jedes der L ersten Pfade basierend auf der folgenden Formel wobei die Formel lautet:

$$P_m = \ln(|W^m - Y_1^N|^2),$$

wobei $P_m$ ein Gewichtswert eines m-ten Pfades in den L ersten Pfaden ist, $Y_1^N$ die zu decodierende Sequenz ist, $W^m$ der m-te Pfad in den L ersten Pfaden ist, $\left|W^m - Y_1^N\right|^2$ ein euklidischer Abstand zwischen dem m-ten Pfad und der zu decodierenden Sequenz ist und $1 \leq m \leq L$ ist.

4. Verfahren gemäß Fall B aus Anspruch 2 oder 3,

wobei ein i-tes Bit in der Decodiersequenz der ersten Phase $X_i$ ist und $1 \leq i \leq N$ ist; wenn die i-ten Bits der L ersten Pfade alle 0 sind, wird ein Softbit-Wert des i-ten Bits $X_i$ in der Decodiersequenz der ersten Phase unter Verwendung eines minimalen Gewichtswertes eines Pfades, dessen i-tes Bit 0 ist, in den L ersten Pfaden bestimmt, wobei $1 \leq i \leq N$ ist;
wenn die i-ten Bits der L ersten Pfade alle 1 sind, wird ein Softbit-Wert des i-ten Bits $X_i$ in der Decodiersequenz der ersten Phase unter Verwendung eines minimalen Gewichtswertes eines Pfades, dessen i-tes Bit 1 ist, in den L ersten Pfaden bestimmt; oder
andernfalls wird ein Softbit-Wert des i-ten Bits $X_i$ in der Decodiersequenz der ersten Phase unter Verwendung eines minimalen Gewichtswertes eines Pfades, dessen i-tes Bit 0 ist, in den L ersten Pfaden und eines minimalen Gewichtswertes eines Pfades, dessen i-tes Bit 1 ist, in den L ersten Pfaden bestimmt.

5. Verfahren gemäß Anspruch 4, wobei, wenn die i-ten Bits der L ersten Pfade alle 0 sind, der Softbit-Wert des i-ten Bits $X_i$ in der Decodiersequenz der ersten Phase gleich einem Produkt aus einem vierten voreingestellten Wert und einem minimalen Gewichtswert eines Pfades, dessen i-tes Bit 0 ist, in den L ersten Pfaden ist;

wenn alle i-ten Bits der L ersten Pfade 1 sind, der Softbit-Wert des i-ten Bits $U_i$ in der Decodiersequenz der ersten Phase gleich einem Produkt aus einem fünften voreingestellten Wert und einem minimalen Gewichtswert eines Pfades, dessen i-tes Bit 1 ist, in den L ersten Pfaden ist; oder
andernfalls der Softbit-Wert des i-ten Bits $U_i$ in der Decodiersequenz der ersten Phase gleich einer Differenz zwischen einem minimalen Gewichtswert der Gewichtswerte von Pfaden, deren i-te Bits 0 sind, in den L ersten Pfaden und einem minimalen Gewichtswert von Pfaden, deren i-te Bits 1 sind, in den L ersten Pfaden ist.

6. Einrichtung, die dafür ausgelegt ist, das Verfahren gemäß einem der Ansprüche 1 bis 5 zu implementieren.

7. Einrichtung gemäß Anspruch 6, implementiert als eine Kommunikationsvorrichtung (500), umfassend:

eine Erhalteeinheit (501), die dafür ausgelegt ist, eine zu decodierende Sequenz zu erhalten, indem sie ein Kanalausgangssignal von einem Kanal empfängt, wobei ein codiertes Signal über den Kanal gesendet wird, wobei das codierte Signal durch eine Sendeeinrichtung durch Quellencodierung und Kanalcodierung eines zu sendenden Signals und durch Ratenanpassung und digitale Modulation des codierten Signals erhalten wird, wobei das zu sendende Signal ein Signal vor der Codierung ist und ein festes Bit und ein Informationsbit enthält, wobei die Länge der zu decodierenden Sequenz N ist und N eine positive ganze Zahl ist;
wobei die Kommunikationsvorrichtung ausgelegt ist für die digitale Demodulation und Kanaldecodierung mit Ratenrückanpassung ("Derate-Matching") sowie die Quellendecodierung und schließlich die Wiederherstellung des Signals; wobei die Kommunikationsvorrichtung ferner umfasst: eine erste Decodiereinheit (502), die dafür ausgelegt ist, L erste Pfade und einen Gewichtswert für jeden der L ersten Pfade zu erhalten, wobei L eine positive ganze Zahl ist, jeder der L ersten Pfade M Bits umfasst und M eine positive ganze Zahl kleiner oder gleich N ist;
eine erste Berechnungseinheit (503), die dafür ausgelegt ist, Softbit-Werte einer Decodiersequenz einer ersten Phase basierend auf den L ersten Pfaden und dem Gewichtswert jedes der L ersten Pfade zu berechnen, wobei eine Länge der Decodiersequenz der ersten Phase P ist und P eine positive ganze Zahl kleiner oder gleich M ist; wobei entweder die Softbit-Werte des Signals vor der Codierung zuerst berechnet werden und dann die Softbit-Werte des Signals nach der Codierung basierend auf einem Faktorgraphen des Polarcodes berechnet werden, oder Softbit-Werte des Signals nach der Codierung direkt berechnet werden; und
eine zweite Decodiereinheit (504), die dafür ausgelegt ist, die Softbit-Werte der Decodiersequenz der ersten Phase zu decodieren, um ein Decodierergebnis zu erhalten;
**dadurch gekennzeichnet, dass**
N=M=P ist; und, Fall A, die Softbit-Werte des Signals vor der Codierung zuerst berechnet werden und dann die Softbit-Werte des Signals nach der Codierung basierend auf einem Faktorgraphen des Polarcodes berechnet werden, die erste Decodiereinheit (502) dafür ausgelegt ist, die L ersten Pfade und den Gewichtswert jedes der L ersten Pfade durch sukzessive Löschungslisten/SC-Listen-Decodierung zu erhalten, und die erste Berechnungseinheit (503) nach der Berechnung der Softbit-Werte des Signals vor der Codierung ferner dafür ausgelegt ist:

die Softbit-Werte des codierten Signals durch Ausführen einer iterativen Softbit-Decodierung an den Softbit-Werten der Decodiersequenz der ersten Phase zu berechnen, um Softbit-Werte einer Decodiersequenz einer zweiten Stufe zu erhalten, wobei eine Länge der Decodiersequenz der zweiten Stufe N ist und die Softbit-Werte einer Decodiersequenz der zweiten Stufe die Softbit-Werte des codierten Signals sind;
oder, Fall B, die Softbit-Werte des Signals nach der Codierung direkt berechnet werden und die erste Decodiereinheit (502) dafür ausgelegt ist, die L ersten Pfade und den Gewichtswert jedes der L ersten Pfade zu erhalten durch:

Durchführen einer SC-Listen-Decodierung an der zu decodierenden Sequenz, um L zweite Pfade zu erhalten, wobei jeder der zweiten Pfade N Bits umfasst;
Durchführen einer Polarcodierung auf jedem der L zweiten Pfade, um die L ersten Pfade zu erhalten; und
Berechnen eines Gewichtswertes für jeden der L ersten Pfade basierend auf einem euklidischen Abstand zwischen jedem der L zweiten Pfade und der zu decodierenden Sequenz.

8. Computerlesbares Speichermedium, wobei das computerlesbare Speichermedium ein Computerprogramm speichert, und wenn das Computerprogramm durch einen Prozessor ausgeführt wird, das Verfahren gemäß einem der Ansprüche 1 bis 5 implementiert wird.

9. Computerprogrammprodukt, wobei, wenn das Computerprogrammprodukt auf einem Computer ausgeführt wird, der Computer in die Lage versetzt wird, das Verfahren gemäß einem der Ansprüche 1 bis 5 durchzuführen.

10. Kommunikationschip (190), umfassend einen Prozessor (1901) und eine oder mehrere mit dem Prozessor (1901) gekoppelte Schnittstellen, wobei der Prozessor (1901) dafür ausgelegt ist, Programmcode aus einem Speicher aufzurufen, um das Verfahren gemäß einem der Ansprüche 1 bis 5 durchzuführen, und die Schnittstelle dafür ausgelegt ist, ein Verarbeitungsergebnis des Prozessors (1901) auszugeben.

## Revendications

1. Procédé de décodage de code polaire, comprenant :

l'obtention (S101) d'une séquence à décoder par la réception par un dispositif de réception d'un signal de sortie de canal depuis un canal, dans lequel un signal codé est envoyé par un appareil d'envoi par l'intermédiaire du canal, dans lequel le signal codé est obtenu, par l'appareil d'envoi, par codage de source et codage de canal sur un signal à envoyer et correspondance de débit et modulation numérique sur le signal codé, dans lequel le signal à envoyer est un signal avant codage et comprend un bit fixe et un bit d'information, dans lequel une longueur de la séquence à décoder est N, et N est un entier positif ;
l'exécution, par l'appareil de réception, d'une démodulation numérique et d'une décorrélation de débit ;
et l'exécution, par l'appareil de réception, d'un décodage de canal et d'un décodage de source, et enfin la restauration du signal par : l'obtention de L premiers chemins et d'une valeur de poids de chacun des L premiers chemins, dans lequel L est un entier positif, chacun des L premiers chemins comprend M bits, et M est un entier positif inférieur ou égal à N ;
le calcul (S103) de valeurs binaires logicielles d'une séquence de décodage de première phase sur la base des L premiers chemins et de la valeur de poids de chacun des L premiers chemins, dans lequel une longueur de la séquence de décodage de première phase est P, et P est un entier positif inférieur ou égal à M, dans lequel, soit les valeurs binaires logicielles du signal avant codage sont d'abord calculées, puis les valeurs binaires logicielles du signal après codage sont calculées sur la base d'un graphique factoriel du code polaire, soit les valeurs binaires logicielles du signal après codage sont calculées directement ; et
le décodage (S104) des valeurs binaires logicielles de la séquence de décodage de première phase pour obtenir un résultat de décodage ;
**caractérisé en ce que**
N = M = P ; et Cas A, les valeurs binaires logicielles du signal avant codage sont d'abord calculées, puis les valeurs binaires logicielles du signal après codage sont calculées sur la base d'un graphique factoriel du code polaire, dans lequel un décodage de liste d'annulations successives, SC-liste, est exécuté sur la séquence à décoder pour obtenir les L premiers chemins et la valeur de poids de chacun des L premiers chemins, et

après le calcul des valeurs binaires logicielles du signal avant codage, le procédé comprend en outre :

le calcul des valeurs binaires logicielles du signal après codage sur la base d'un graphique factoriel du code polaire par l'exécution d'un décodage itératif de bits logiciels sur les valeurs binaires logicielles de la séquence de décodage de première phase pour obtenir des valeurs binaires logicielles d'une séquence de décodage de seconde phase, dans lequel une longueur de la séquence de décodage de seconde phase est N et les valeurs binaires logicielles d'une séquence de décodage de seconde phase sont les valeurs binaires logicielles du signal codé ;

ou, Cas B, les valeurs binaires logicielles du signal après codage sont calculées directement, et les L premiers chemins et la valeur de poids de chacun des L premiers chemins sont obtenus par :

l'exécution d'un décodage de SC-liste sur la séquence à décoder, pour obtenir L seconds chemins, dans lequel chacun des seconds chemins comprend N bits ;

l'exécution d'un codage polaire sur chacun des L seconds chemins pour obtenir les L premiers chemins ; et

le calcul d'une valeur de poids de chacun des L premiers chemins sur la base d'une distance euclidienne entre chacun des L seconds chemins et la séquence à décoder.

2. Procédé selon le Cas A de la revendication 1, dans lequel l'exécution d'un décodage itératif de bits logiciels sur les valeurs binaires logicielles de la séquence de décodage de première phase pour obtenir des valeurs binaires logicielles d'une séquence de décodage de seconde phase comprend :

l'exécution d'un décodage itératif de bits logiciels par graphique factoriel 2x2 couche par couche sur les valeurs binaires logicielles de la séquence de décodage de première phase pour obtenir les valeurs binaires logicielles de la séquence de décodage de seconde phase ; ou

l'exécution d'un décodage itératif de bits logiciels par graphique factoriel NxN sur les valeurs binaires logicielles de la séquence de décodage de première phase pour obtenir les valeurs binaires logicielles de la séquence de décodage de seconde phase.

3. Procédé selon le Cas B de la revendication 1, dans lequel le calcul de la valeur de poids de chacun des L premiers chemins sur la base d'une distance euclidienne entre chacun des L premiers chemins et la séquence à décoder comprend :

le calcul de la valeur de poids de chacun des L premiers chemins sur la base de la formule suivante, dans lequel la formule est :

$$P_m = \ln(|W^m - Y_1^N|^2),$$

$P_m$ est une valeur de poids d'un $m^{ème}$ chemin des L premiers chemins, Yf est la séquence à décoder, $W^m$ est le $m^{ème}$ chemin des L premiers chemins, $|W^m - \tilde{Y}_1^N|^2$ est une distance euclidienne entre le $m^{ème}$ chemin et la séquence à décoder, et $1 \leq m \leq L$.

4. Procédé selon le Cas B de la revendication 2 ou 3, dans lequel un $i^{ème}$ bit de la séquence de décodage de première phase est $X_i$, et $1 \leq i \leq N$ ;

si les $i^{ème}$ bits des L premiers chemins sont tous 0, une valeur binaire logicielle du $i^{ème}$ bit $X_i$ dans la séquence de décodage de première phase est déterminée au moyen d'une valeur de poids minimale d'un chemin dont le $i^{ème}$ bit est 0 dans les L premiers chemins, dans lequel $1 \leq i \leq N$ ;

si les $i^{ème}$ bits des L premiers chemins sont tous 1, une valeur binaire logicielle du $i^{ème}$ bit $X_i$ dans la séquence de décodage de première phase est déterminée au moyen d'une valeur de poids minimale d'un chemin dont le $i^{ème}$ bit est 1 dans les L premiers chemins ; ou

sinon, une valeur binaire logicielle du $i^{ème}$ bit $X_i$ dans la séquence de décodage de première phase est déterminée au moyen d'une valeur de poids minimale d'un chemin dont le $i^{ème}$ bit est 0 dans les L premiers chemins et d'une valeur de poids minimale d'un chemin dont le $i^{ème}$ bit est 1 dans les L premiers chemins.

5. Procédé selon la revendication 4, dans lequel si les $i^{ème}$ bits des L premiers chemins sont tous 0, la valeur binaire logicielle du $i^{ème}$ bit $X_i$ dans la séquence de décodage de première phase est égale à un produit d'une quatrième valeur prédéfinie et d'une valeur de poids minimale d'un chemin dont le $i^{ème}$ bit est 0 dans les L premiers chemins ;

si tous les $i^{ème}$ bits des L premiers chemins sont 1, la valeur binaire logicielle du $i^{ème}$ bit $U_i$ dans la séquence de décodage de première phase est égale à un produit d'une cinquième valeur prédéfinie et d'une valeur de poids minimale d'un chemin dont le $i^{ème}$ bit est 1 dans les L premiers chemins ; ou

sinon, la valeur binaire logicielle du $i^{ème}$ bit $U_i$ dans la séquence de décodage de première phase est égale à une différence entre une valeur de poids minimale parmi les valeurs de poids de chemins dont les $i^{ème}$ bits sont 0 dans les L premiers chemins et une valeur de poids minimale de chemins dont les $i^{ème}$ bits sont 1 dans les L premiers chemins.

6. Appareil configuré pour mettre en oeuvre le procédé selon l'une quelconque des revendications 1 à 5.

7. Appareil selon la revendication 6 mis en oeuvre en tant que dispositif de communication (500), comprenant :

une unité d'obtention (501), configurée pour obtenir une séquence à décoder par la réception d'un signal de sortie de canal depuis un canal, dans lequel un signal codé est envoyé par l'intermédiaire du canal, dans lequel le signal codé est obtenu, par un appareil d'envoi, par codage de source et codage de canal sur un signal à envoyer et correspondance de débit et modulation numérique sur le signal codé, dans lequel le signal à envoyer est un signal avant codage et comprend un bit fixe et un bit d'information, dans lequel une longueur de la séquence à décoder est N, et N est un entier positif ;

dans lequel le dispositif de communication est configuré pour un décodage de canal par démodulation numérique et décorrélation de débit et un décodage de source, et enfin une restauration du signal ;

dans lequel le dispositif de communication comprend en outre : une première unité de décodage (502), configurée pour obtenir L premiers chemins et une valeur de poids de chacun des L premiers chemins, dans lequel L est un entier positif, chacun des L premiers chemins comprend M bits, et M est un entier positif inférieur ou égal à N ;

une première unité de calcul (503), configurée pour calculer des valeurs binaires logicielles d'une séquence de décodage de première phase sur la base des L premiers chemins et de la valeur de poids de chacun des L premiers chemins, dans lequel une longueur de la séquence de décodage de première phase est P, et P est un entier positif inférieur ou égal à M ; dans lequel, soit les valeurs binaires logicielles du signal avant codage sont d'abord calculées, puis les valeurs binaires logicielles du signal après codage sont calculées sur la base d'un graphique factoriel du code polaire, soit les valeurs binaires logicielles du signal après codage sont calculées directement ; et

une seconde unité de décodage (504), configurée pour décoder les valeurs binaires logicielles de la séquence de décodage de première phase pour obtenir un résultat de décodage ;

**caractérisé en ce que**

N = M = P ; et Cas A, les valeurs binaires logicielles du signal avant codage sont d'abord calculées, puis les valeurs binaires logicielles du signal après codage sont calculées sur la base d'un graphique factoriel du code polaire, la première unité de décodage (502) est configurée pour obtenir les L premiers chemins et la valeur de poids de chacun des L premiers chemins par un décodage de liste d'annulations successives, SC-liste, et après le calcul des valeurs binaires logicielles du signal avant codage, la première unité de calcul (503) est en outre configurée pour :

calculer les valeurs binaires logicielles du signal codé par l'exécution d'un décodage itératif de bits logiciels sur les valeurs binaires logicielles de la séquence de décodage de première phase pour obtenir des valeurs binaires logicielles d'une séquence de décodage de seconde phase, dans lequel une longueur de la séquence de décodage de seconde phase est N et les valeurs binaires logicielles d'une séquence de décodage de seconde phase sont les valeurs binaires logicielles du signal codé ;

ou, Cas B, les valeurs binaires logicielles du signal après codage sont calculées directement, et la première unité de décodage (502) est configurée pour obtenir les L premiers chemins et la valeur de poids de chacun des L premiers chemins par :

l'exécution d'un décodage de SC-liste sur la séquence à décoder, pour obtenir L seconds chemins, dans lequel chacun des seconds chemins comprend N bits ;

l'exécution d'un codage polaire sur chacun des L seconds chemins pour obtenir les L premiers chemins ; et

le calcul d'une valeur de poids de chacun des L premiers chemins sur la base d'une distance euclidienne entre chacun des L seconds chemins et la séquence à décoder.

8. Support de stockage lisible par ordinateur, le support de stockage lisible par ordinateur stockant un programme informatique, et lorsque le programme informatique est exécuté par un processeur, le procédé selon l'une quelconque des revendications 1 à 5 étant mis en oeuvre.

9. Produit programme informatique, dans lequel lorsque le produit programme informatique est exécuté sur un ordinateur, l'ordinateur est activé pour exécuter le procédé selon l'une quelconque des revendications 1 à 5.

10. Puce de communication (190), comprenant un processeur (1901) et une ou plusieurs interfaces couplées au processeur (1901), dans lequel le processeur (1901) est configuré pour appeler le code de programme depuis une mémoire pour exécuter le procédé selon l'une quelconque des revendications 1 à 5, et l'interface est configurée pour délivrer un résultat de traitement du processeur (1901).

**Communications system 100**

FIG. 1

**Terminal device 200**

FIG. 2

Network device 300

FIG. 3

FIG. 4

FIG. 5

FIG. 6

FIG. 7

FIG. 8

A communications device obtains a to-be-decoded sequence, where a length of the to-be-decoded sequence is N, and N is a positive integer — S101

The communications device performs SCL decoding on the to-be-decoded sequence, to obtain L first paths and a weight value of each of the L first paths, where L is a positive integer, each of the L first paths includes M bits, and M is a positive integer less than or equal to N — S102

The communications device calculates soft bit values of a first-phase decoding sequence based on the L first paths and the weight value of each of the L first paths, where the length of the first-phase decoding sequence is P, and P is a positive integer less than or equal to M — S103

The communications device decodes the soft bit values of the first-phase decoding sequence to obtain a decoding result — S104

FIG. 9

L candidate paths: $R^1$, $R^2$, ..., and $R^L$

```
┌─────────────────┐         ┌──────────────────┐
│                 │         │  Successive      │───▶ Candidate path $R^1$   $R_1^1$ $R_2^1$ $R_3^1$ ⋯ $R_i^1$ ⋯ $R_N^1$   Path weight value: $P_1$
│ To-be-decoded   │────────▶│  cancellation    │
│ sequence $Y_1^N$│         │  list (SCL)      │───▶ Candidate path $R^2$   $R_1^2$ $R_2^2$ $R_3^2$ ⋯ $R_i^2$ ⋯ $R_N^2$   Path weight value: $P_2$
│                 │         │  decoder         │
└─────────────────┘         │                  │  ...
                            │                  │───▶ Candidate path $R^L$   $R_1^L$ $R_2^L$ $R_3^L$ ⋯ $R_i^L$ ⋯ $R_N^L$   Path weight value: $P_L$
                            └──────────────────┘
```

FIG. 10

FIG. 11

EP 3 720 023 B1

FIG. 12

L candidate paths: $R^1$, $R^2$, ..., and $R^L$

To-be-decoded sequence $Y_1^N$ → Successive cancellation list (SCL) decoder

...

Candidate path $R^1$ | $R_1^1$ | $R_2^1$ | $R_3^1$ | ... | $R_i^1$ | ... | $R_k^1$ | Path weight value: $P_1$

Candidate path $R^2$ | $R_1^2$ | $R_2^2$ | $R_3^2$ | ... | $R_i^2$ | ... | $R_k^2$ | Path weight value: $P_2$

Candidate path $R^L$ | $R_1^L$ | $R_2^L$ | $R_3^L$ | ... | $R_i^L$ | ... | $R_k^L$ | Path weight value: $P_L$

FIG. 13

This part of partially polarized bits are re-coded by using an LDPC code

Extended decoding diagram (LDPC decoding)

Standard decoding diagram (Polar decoding)

FIG. 14

Receive a channel output signal $Y_1^N$

Calculate a soft bit value $S(X_1^N)$ of an end X

Calculate a soft bit value $S(U_1^N)$ of an end U

Update $S(U_1^N)$ based on a factor graph of a low-density parity-check LDPC code

Determine $U_1^N$

FIG. 15

Receive a signal $C_1^n$

Calculate a soft bit value $S(A_1^N)$ of a user 1

Calculate a soft bit value $S(A\_U_1^N)$ of an end U of the user 1 in a belief propagation (BP) decoding manner

Reversely update the soft bit value $S(A_1^N)$ of the user 1 in the BP decoding manner

Whether a quantity of times of inner-loop iteration is reached

No

Yes

Update a soft bit value $S(B_1^N)$ of a user 2 based on $C_1^n$ and $S(A_1^N)$

Calculate a soft bit value $S(B\_U_1^N)$ of an end U of the user 2 in a BP decoding manner

Reversely update the soft bit value $S(B_1^N)$ of the user 2 in the BP decoding manner

Whether a quantity of times of inner-loop iteration is reached

No

Yes

Whether a quantity of times of outer-loop iteration is reached

No

Yes

Determine $A_1^N$ and $B_1^N$

BP inner-loop iteration

BP outer-loop iteration

FIG. 16

Receive a signal $C_1^n$

Determine $A_1^N$ and $B_1^N$

Calculate a soft bit value $S(A_1^N)$ of a user 1

No ← Whether a quantity of times of outer-loop iteration is reached

Yes

Calculate L candidate paths $R_1^N$ of the user 1 and a weight value of each candidate path in a successive cancellation (SCL) decoding manner

Calculate a soft bit value $S(A\_U_1^N)$ of an end U of the user 1 based on the L candidate paths $R_1^N$ and the weight value

Reversely update the soft bit value $S(A_1^N)$ of an ene X of the user 1

Reversely update the soft bit value $S(B_1^N)$ of an end X of the user 2

Calculate a soft bit value $S(B\_U_1^N)$ of an end U of the user 2 based on the L candidate paths $R_1^N$ and the weight value

Calculate L candidate paths of the user 2 and a weight value of each candidate path in the SCL decoding manner

Update a soft bit value $S(B_1^N)$ of a user 2 based on $C_1^n$ and $S(A_1^N)$

BP outer-loop iteration

FIG. 17

500

Communications device

| 501 | 502 | 503 | 504 |
|---|---|---|---|
| Obtaining unit | First decoding unit | First calculation unit | Second decoding unit |

FIG. 18

**Communications chip 190**

Processor 1901

Bus 1903

General purpose input/output (GPIO) interface 1902

| Display (LCD) | Camera (camera) | Radio frequency (RF) module |
|---|---|---|

FIG. 19

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **Z. LIU ; K. NIU ; J. LIN.** Parallel concatenated systematic polar code based on soft successive cancellation list decoding. *2017 20th International Symposium on Wireless Personal Multimedia Communications (WPMC),* 2017, 181-184

- **FAYYAZ UBAID et al.** Low-Complexity Soft-Output Decoding of Polar Codes. *IEEE Journal on Selected Areas in Communications,* May 2014, vol. 32 (5), ISSN 0733-8716, 958-966